# EUROPEAN PATENT SPECIFICATION

(11) **EP 4 428 901 B1**
(45) Date of publication and mention of the grant of the patent: **27.08.2025**
(21) Application number: 22927870.0
(22) Date of filing: 28.02.2022
(51) Int. Cl.: H01L 21/768, H01L 23/48, H10D 64/23, H10D 30/47, H10D 62/85

(54) **CHIP AND MANUFACTURING METHOD THEREFOR**
CHIP UND HERSTELLUNGSVERFAHREN DAFÜR
PUCE ET SON PROCÉDÉ DE FABRICATION

(43) Date of publication of application: 11.09.2024
(73) Proprietor: Huawei Technologies Co., Ltd., Shenzhen, Guangdong 518129 (CN)
(72) Inventor: LI, Shuiming, Shenzhen, Guangdong 518129 (CN); LI, Haijun, Shenzhen, Guangdong 518129 (CN); ZHANG, Zhili, Shenzhen, Guangdong 518129 (CN); LIU, Tao, Shenzhen, Guangdong 518129 (CN); RAO, Jin, Shenzhen, Guangdong 518129 (CN)
(74) Representative: Pfenning, Meinig & Partner mbB
(86) International application number: PCT/CN2022/078378
(87) International publication number: WO 2023/159589

(56) References cited:
- CN-A- 101 467 265
- CN-A- 106 252 310
- CN-A- 107 578 992
- CN-A- 108 172 563
- US-A- 5 343 071
- US-A1- 2008 073 752
- US-A1- 2011 115 025
- US-A1- 2012 286 878
- US-A1- 2017 069 619

## Description

### TECHNICAL FIELD

This application relates to the field of semiconductor technologies, and in particular, to a chip and a chip preparation method

### BACKGROUND

Radio frequency components based on compound semiconductor materials are widely used in base stations, radars, consumer electronics, and other products. A radio frequency component, for example, a transistor, generally includes a source, a gate, and a drain. The source may be grounded through conductive wire bonding.

However, there is parasitic inductance on a conductive wire, and the source of the transistor is electrically connected to the conductive wire. As a result, parasitic inductance of the source is increased, and a gain of the transistor is reduced.

Therefore, the source of the transistor is usually directly grounded through a back hole of a substrate, instead of being grounded through conductive wire bonding. In this way, a parasitic parameter can be reduced, and performance of the transistor can be improved. However, because the back hole of the substrate is usually designed right below a source metal, a design in which the back hole of the substrate is introduced inevitably increases a width of the source metal. This increases an area of a transistor chip and increases costs of the radio frequency component.

US 2008073752 A1 discloses a GaAs field effect transistor of the prior art, comprising a source via extending through adjacent source electrodes.

### SUMMARY

To resolve the foregoing technical problems, this application provides a chip and a chip preparation method, to avoid a case in which a source conducting layer is incorrectly etched and consequently an epitaxial layer cannot be in full contact with the source conducting layer when a layout area of the chip is reduced.

According to a first aspect, this application provides a chip preparation method. A chip includes a first transistor and a second transistor, and the chip preparation method includes: first forming, on a substrate, an epitaxial layer and a source conducting layer that are sequentially disposed in a stacked manner, where the epitaxial layer includes a first via, to form a first epitaxial layer of the first transistor and a second epitaxial layer of the second transistor; the source conducting layer includes a first source of the first transistor and a second source of the second transistor; the first source is disposed on a side of the first epitaxial layer opposite to the substrate, and the second source is disposed on a side of the second epitaxial layer opposite to the substrate; and an edge of the first source is flush with an edge of the first epitaxial layer close to a side of the first via, and an edge of the second source is flush with an edge of the second epitaxial layer close to a side of the first via; then, forming a first conducting layer, where the first conducting layer is filled in the first via, and is in contact with the first source and the second source separately; then, forming a second via on the substrate, where the second via and the first via at least partially overlap; and then, forming a second conducting layer, where the second conducting layer is located in the second via, and the second conducting layer is in contact with the first conducting layer and is grounded.

In the solution of this application, the epitaxial layer is formed through a front-side lithography process. To be specific, lithography is performed on a semiconductor film along a direction from the source conducting layer to the semiconductor film. In addition, lithography precision of the front-side lithography process may be less than 100 nm, and is far higher than that of a back-side lithography process. Therefore, when the semiconductor film is etched, a case in which the source conducting layer is incorrectly etched and the first epitaxial layer and the second epitaxial layer are over-etched due to a deviation of the lithography process is avoided, so that it can be ensured that the first epitaxial layer is in full contact with the first source, and the second epitaxial layer is in full contact with the second source. When the first transistor is connected, the first epitaxial layer may effectively transmit a current to the first source, and then the first source releases the current to the ground through the first conducting layer and the second conducting layer. When the second transistor is connected, the second epitaxial layer may effectively transmit a current to the second source, and then the second source releases the current to the ground through the first conducting layer and the second conducting layer. In addition, in comparison with a related technology, in the transistors in this application, a length of the first epitaxial layer protruding from the first source and a length of the second epitaxial layer protruding from the second source do not need to be reserved. Therefore, layout areas of the first transistor, the second transistor, and even the chip can be reduced.

In a possible implementation, the step of forming, on a substrate, an epitaxial layer and a source conducting layer that are sequentially disposed in a stacked manner specifically includes: first sequentially forming the semiconductor film and the source conducting layer on the substrate; and then, providing the first via in the semiconductor film, to obtain the epitaxial layer.

In this case, the edge of the first source is flush with the edge of the first epitaxial layer close to the side of the first via, and the edge of the second source is flush with the edge of the second epitaxial layer close to the side of the first via. Alternatively, due to a process reason, there may be a tolerance between the actually formed first epitaxial layer and first source, and there may be a tolerance between the second epitaxial layer and the second source. A surface of the first epitaxial layer opposite to the substrate may also be flush with the edge of the first source, and a surface of the second epitaxial layer opposite to the substrate may also be flush with the edge of the second source. However, a surface that is of the first epitaxial layer and that faces the substrate may protrude from the edge of the first source, and a surface that is of the second epitaxial layer and that faces the substrate may protrude from the edge of the second source.

In another possible implementation, the step of forming, on a substrate, an epitaxial layer and a source conducting layer that are disposed in a stacked manner specifically includes: first forming a semiconductor film on the substrate; then, providing the first via in the semiconductor film, to obtain the epitaxial layer; and then, forming the source conducting layer on a side of the epitaxial layer opposite to the substrate. Because the first source and the second source are formed after the first epitaxial layer and the second epitaxial layer are formed, an etching material for etching the semiconductor film does not affect patterns of the first source and the second source.

In this case, the edge of the first source is flush with the edge of the first epitaxial layer close to the side of the first via, and the edge of the second source is flush with the edge of the second epitaxial layer close to the side of the first via. Alternatively, a part of the first source and a part of the second source further extend to the first via. Alternatively, due to a process reason, there may be a tolerance between the actually formed first epitaxial layer and first source, and there may be a tolerance between the second epitaxial layer and the second source. A surface of the first epitaxial layer opposite to the substrate may also be flush with the edge of the first source, and a surface of the second epitaxial layer opposite to the substrate may also be flush with the edge of the second source. However, a surface that is of the first epitaxial layer and that faces the substrate may protrude from the edge of the first source, and a surface that is of the second epitaxial layer and that faces the substrate may protrude from the edge of the second source.

In some possible implementations, in the foregoing two implementations, the step of providing the first via in the semiconductor film, to obtain the epitaxial layer specifically includes: first forming a photoresist on a side of the semiconductor film opposite to the substrate; then, exposing the photoresist, and developing the photoresist to obtain a photoresist pattern; and then, etching the semiconductor film along a direction from the epitaxial layer to the substrate, to obtain the first epitaxial layer and the second epitaxial layer.

In some possible implementations, the semiconductor film may be etched through the front-side lithography process. The precision of the front-side lithography process is higher than that of the back-side lithography process, and alignment precision of the front-side lithography process can be less than 100 nm. Therefore, when the semiconductor film is etched through the front-side lithography process, a case in which the first source and the second source are incorrectly etched and the first epitaxial layer and the second epitaxial layer are over-etched due to the deviation of the lithography process is avoided, so that it is ensured that the first source is in full contact with the first epitaxial layer, and it is ensured that the second source is in full contact with the second epitaxial layer.

In some possible implementations, although a commonly used chlorine-based gas has etching effect on materials of the first epitaxial layer and the second epitaxial layer, and materials of the first source and the second source, because the semiconductor film is etched through the front-side lithography process in this application, and the alignment precision is very high, the chlorine-based gas is not in contact with the first source and the second source, and therefore does not affect the pattern of the source. Based on this, in this application, etching may be further performed on the semiconductor film by using the chlorine-based gas, to obtain the first epitaxial layer and the second epitaxial layer.

In some possible implementations, the step of forming a second via specifically includes: etching the substrate along a direction from the substrate to the epitaxial layer, to obtain the second via.

In some possible implementations, the first via and the second via are disposed oppositely, and an edge that is of the first source and that faces the second source is flush with an edge that is of the first epitaxial layer and that faces the second epitaxial layer. In other words, the edge of the first source is flush with the edge of the first epitaxial layer close to the side of the first via, and the edge of the second source is flush with the edge of the second epitaxial layer close to the side of the first via, so that the second conducting layer is in contact with the first conducting layer. In addition, along a direction from the first source to the second source, a length of the first via is the same as a length of the second via. In this way, the second conducting layer to be formed may be in full contact with the first conducting layer.

In some possible implementations, the first via and the second via are disposed oppositely, so that the second conducting layer is in contact with the first conducting layer. In addition, along the direction from the first source to the second source, the length of the first via is less than the length of the second via. In this way, the second conducting layer to be formed may be in full contact with the first conducting layer. In addition, the length of the first via may be reduced while the length of the second via remains unchanged. This further reduces the layout areas occupied by the first transistor and the second transistor.

In some possible implementations, the first via and the second via are not disposed oppositely, but the second conducting layer is still in contact with the first conducting layer. In addition, along the direction from the first source to the second source, the length of the first via is less than the length of the second via. In this way, the length of the first via may be reduced while the length of the second via remains unchanged. This further reduces the layout areas occupied by the first transistor and the second transistor.

In some possible implementations, the first via and the second via may be disposed oppositely, or may not be disposed oppositely, and the second conducting layer is in contact with the first conducting layer. In addition, orthographic projections of the source conducting layer and the first via on the substrate are within a range of the second via, and along the direction from the first source to the second source, a total length from an edge of the first source opposite to the second source to an edge of the second source opposite to the first source is less than the length of the second via. In this way, the second conducting layer to be formed may be in full contact with the first conducting layer. In addition, a first gate is disposed on a side of the epitaxial layer opposite to the substrate, the first gate is located on a side of the first source opposite to the second source, and a second gate is located on a side of the second source opposite to the first source. A material of the second conducting layer may be a metal material, and a thermal conductivity of the metal material is higher than a thermal conductivity of a material of the substrate. Therefore, when the first gate and the second gate generate heat, the heat on the first gate may be conducted to the second conducting layer through the first epitaxial layer, and the heat on the second gate may be conducted to the second conducting layer through the second epitaxial layer, to avoid impact on performance of the transistor due to excessively high temperatures of the first gate and the second gate.

According to a second aspect, this application provides a chip. The chip may be prepared by using the method according to the first aspect. The chip includes a substrate and a first transistor and a second transistor that are disposed on the substrate. The first transistor includes a first epitaxial layer and a first source that are sequentially disposed on the substrate in a stacked manner, the second transistor includes a second epitaxial layer and a second source that are sequentially disposed on the substrate in the stacked manner, and a first via is provided between the first epitaxial layer and the second epitaxial layer. An edge of the first source is flush with an edge of the first epitaxial layer close to a side of the first via, and an edge of the second source is flush with an edge of the second epitaxial layer close to a side of the first via. The chip further includes a first conducting layer, where the first conducting layer is in contact with the first source and the second source separately, and is filled in the first via between the first epitaxial layer and the second epitaxial layer. The substrate includes a second via, and the chip further includes a second conducting layer, where the second conducting layer is filled in the second via, and the second conducting layer is in contact with the first conducting layer and is grounded.

In the solution of this application, the first epitaxial layer and the second epitaxial layer are formed through a front-side lithography process. To be specific, lithography is performed on a semiconductor film along a direction from a source conducting layer to the semiconductor film. In addition, lithography precision of the front-side lithography process may be less than 100 nm, and is far higher than that of a back-side lithography process. Therefore, when the semiconductor film is etched, a case in which the source conducting layer is incorrectly etched and the epitaxial layer is over-etched due to a deviation of the lithography process is avoided, so that it can be ensured that the epitaxial layer is in full contact with the first source and the second source separately. When the first transistor is connected, the first epitaxial layer may effectively transmit a current to the first source, and then the first source releases the current to the ground through the first conducting layer and the second conducting layer. When the second transistor is connected, the second epitaxial layer may effectively transmit a current to the second source, and then the second source releases the current to the ground through the first conducting layer and the second conducting layer. In addition, in comparison with a related technology, in the transistors in this application, a length L2 of the epitaxial layer protruding from the source does not need to be reserved. Therefore, layout areas of the first transistor, the second transistor, and even the chip can be reduced.

In a possible implementation, the edge of the first source is flush with the edge of the first epitaxial layer close to the side of the first via, and the edge of the second source is flush with the edge of the second epitaxial layer close to the side of the first via. A structure in this implementation may be implemented through the process in the first aspect. Specifically, the structure may be implemented by sequentially forming the semiconductor film and the source conducting layer on the substrate first, and then providing the first via in the semiconductor film, to obtain the epitaxial layer. Alternatively, the semiconductor film may be first formed on the substrate, then the first via is provided in the semiconductor film, to obtain the epitaxial layer, and then the source conducting layer is formed on a side of the epitaxial layer opposite to the substrate.

In another possible implementation, an edge that is of the first source and that faces the second source protrudes from an edge that is of the first epitaxial layer and that faces the second epitaxial layer; and an edge that is of the second source and that faces the first source protrudes from an edge that is of the second epitaxial layer and that faces the first epitaxial layer. In other words, a part of the first source and a part of the second source further extend to the first via. A structure in this implementation may be implemented through the process in the first aspect. Specifically, the semiconductor film may be first formed on the substrate, and then the first via is provided in the semiconductor film, to obtain the first epitaxial layer and the second epitaxial layer. Then, the first source is formed on a side of the first epitaxial layer opposite to the substrate, and the second source is formed on a side of the second epitaxial layer opposite to the substrate.

In addition, due to a process reason, there may be a tolerance between the actually formed first epitaxial layer and first source, and there may be a tolerance between the second epitaxial layer and the second source. A surface of the first epitaxial layer opposite to the substrate may also be flush with the edge of the first source, and a surface of the second epitaxial layer opposite to the substrate may also be flush with the edge of the second source. However, a surface that is of the first epitaxial layer and that faces the substrate may protrude from the edge of the first source, and a surface that is of the second epitaxial layer and that faces the substrate may protrude from the edge of the second source.

In some possible implementations, the first via and the second via are disposed oppositely, and the edge that is of the first source and that faces the second source is flush with the edge that is of the first epitaxial layer and that faces the second epitaxial layer. In other words, the edge of the first source is flush with the edge of the first epitaxial layer close to the side of the first via, and the edge of the second source is flush with the edge of the second epitaxial layer close to the side of the first via, so that the second conducting layer is in contact with the first conducting layer. In addition, along a direction from the first source to the second source, a length of the first via is the same as a length of the second via. In this way, the second conducting layer to be formed may be in full contact with the first conducting layer.

In some possible implementations, the first via and the second via are disposed oppositely, so that the second conducting layer is in contact with the first conducting layer. In addition, along the direction from the first source to the second source, the length of the first via is less than the length of the second via. In this way, the second conducting layer to be formed may be in full contact with the first conducting layer. In addition, the length of the first via may be reduced while the length of the second via remains unchanged. This further reduces the layout areas occupied by the first transistor and the second transistor.

In some possible implementations, the first via and the second via are not disposed oppositely, but the second conducting layer is still in contact with the first conducting layer. In addition, along the direction from the first source to the second source, the length of the first via is less than the length of the second via. In this way, the length of the first via may be reduced while the length of the second via remains unchanged. This further reduces the layout areas occupied by the first transistor and the second transistor.

In some possible implementations, the first via and the second via may be disposed oppositely, or may not be disposed oppositely, and the second conducting layer is in contact with the first conducting layer. In addition, orthographic projections of the source conducting layer and the first via on the substrate are within a range of the second via, and along the direction from the first source to the second source, a total length from an edge of the first source opposite to the second source to an edge of the second source opposite to the first source is less than the length of the second via. In this way, the second conducting layer to be formed may be in full contact with the first conducting layer. In addition, a first gate is disposed on a side of the epitaxial layer opposite to the substrate, the first gate is located on a side of the first source opposite to the second source, and a second gate is located on a side of the second source opposite to the first source. A material of the second conducting layer may be a metal material, and a thermal conductivity of the metal material is higher than a thermal conductivity of a material of the substrate. Therefore, when the first gate and the second gate generate heat, the heat on the first gate may be exported to the second conducting layer through the first epitaxial layer, and the heat on the second gate may be exported to the second conducting layer through the second epitaxial layer, to avoid impact on performance of the transistor due to excessively high temperatures of the first gate and the second gate.

### BRIEF DESCRIPTION OF DRAWINGS

FIG. 1 is a block diagram of a structure of a terminal according to an embodiment of this application;
FIG. 2 is a circuit diagram of a power amplifier according to an embodiment of this application;
FIG. 3a is a diagram of a structure of a transistor according to a related technology;
FIG. 3b is a diagram of a structure when a source of the transistor in FIG. 3a is incorrectly etched;
FIG. 4a is a diagram of a structure of another transistor according to a related technology;
FIG. 4b is a diagram of a structure when an etching error occurs on a substrate and an epitaxial layer of the transistor in FIG. 3a;
FIG. 5 is a top view of a plurality of transistors according to an embodiment of this application;
FIG. 6 is a schematic flowchart of transistor preparation according to an embodiment of this application;
FIG. 7a is a diagram of a transistor preparation process according to an embodiment of this application;
FIG. 7b is a diagram of a transistor preparation process according to an embodiment of this application;
FIG. 7c is a diagram of a transistor preparation process according to an embodiment of this application;
FIG. 7d is a diagram of a transistor preparation process according to an embodiment of this application;
FIG. 7e is a diagram of a transistor preparation process according to an embodiment of this application;
FIG. 7f is a diagram of a transistor preparation process not forming part of the invention as claimed;
FIG. 7g is a diagram of a transistor preparation process according to an embodiment of this application;
FIG. 7h is a diagram of a transistor preparation process according to an embodiment of this application;
FIG. 7i is a diagram of a transistor preparation process according to an embodiment of this application;
FIG. 7j is a diagram of a transistor preparation process according to an embodiment of this application;
FIG. 7k is a diagram of a transistor preparation process according to an embodiment of this application;
FIG. 7l is a diagram of a transistor preparation process according to an embodiment of this application;
FIG. 7m is a diagram of a transistor preparation process according to an embodiment of this application;
FIG. 7n is a diagram of a transistor preparation process according to an embodiment of this application;
FIG. 7o is a diagram of a transistor preparation process according to an embodiment of this application;
FIG. 8 is a schematic flowchart of another transistor preparation according to an embodiment of this application;
FIG. 9a is a diagram of a transistor preparation process according to an embodiment of this application;
FIG. 9b is a diagram of a transistor preparation process according to an embodiment of this application;
FIG. 9c is a diagram of a transistor preparation process according to an embodiment of this application;
FIG. 9d is a diagram of a transistor preparation process not forming part of the invention as claimed;
FIG. 9e is a diagram of a transistor preparation process not forming part of the invention as claimed;
FIG. 9f is a diagram of a transistor preparation process not forming part of the invention as claimed;
FIG. 9g is a diagram of a transistor preparation process not forming part of the invention as claimed; and
FIG. 9h is a diagram of a transistor preparation process not forming part of the invention as claimed.

### Reference numerals:

101-Baseband processing unit; 102-Transmitter; 1021-Radio frequency signal generation circuit; 1022-Power amplifier; 1023-Filter; 1024-Antenna; 10-Substrate; 11-Epitaxial layer; 101-First epitaxial layer; 102-Second epitaxial layer; 111-Semiconductor film; 12-Source; 13-First conducting layer; 14-Second conducting layer; 21-Source conducting layer; 211-First source; 212-Second source; 22-Drain; 221-First drain; 222-Second drain; 231-First gate; 232-Second gate; and 33-Third photoresist pattern.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application.

The term "and/or" in this specification describes only an association relationship for describing associated objects and represents that three relationships may exist. For example, A and/or B may represent the following three cases: Only A exists, both A and B exist, and only B exists.

In the specification and claims in embodiments of this application, the terms "first", "second", and so on are intended to distinguish between different objects but do not indicate a particular order of the objects. For example, a first target object, a second target object, and the like are used for distinguishing between different target objects, but are not used for describing a specific order of the target objects.

In addition, in embodiments of this application, the word "exemplary" or "for example" is used to represent giving an example, an illustration, or a description. Any embodiment or design scheme described as an "example" or "for example" in embodiments of this application should not be explained as being more preferred or having more advantages than another embodiment or design scheme. To be precise, the word "example", "for example", or the like is intended to present a related concept in a specific manner.

In the descriptions of embodiments of this application, unless otherwise stated, "a plurality of" means two or more than two. For example, a plurality of processing units are two or more processing units, and a plurality of systems are two or more systems.

An embodiment of this application provides a terminal, so that a parasitic capacitance of a source of a transistor can be reduced, a gain of the transistor can be increased, and a layout area of the transistor can be reduced.

The following describes a specific structure and usage of the terminal provided in this embodiment of this application.

The terminal 1 may be a base station, a computer, a tablet computer, a personal digital assistant (personal digital assistant, PDA for short), an intelligent wearable device, a smart home device, or the like. This is not limited in this embodiment of this application.

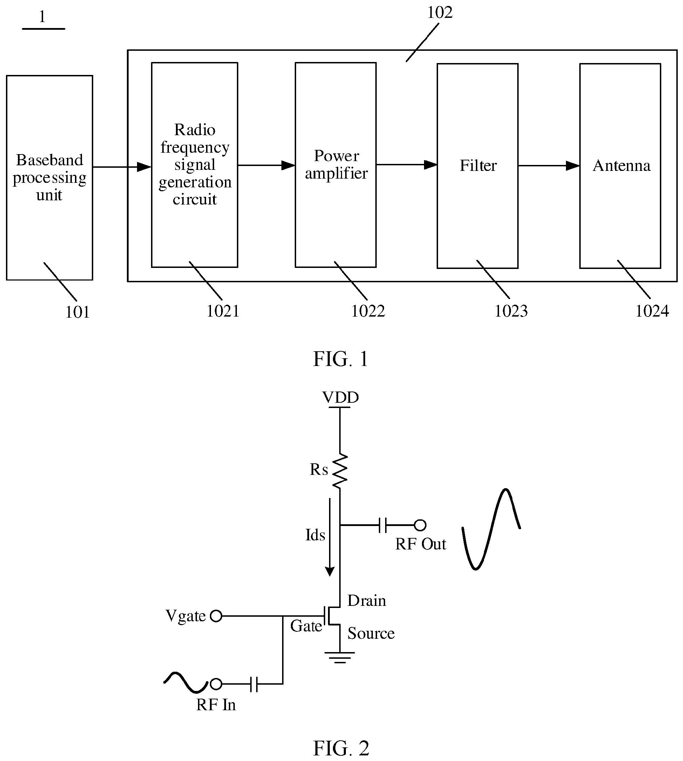

FIG. 1 is a diagram of an application scenario of the terminal 1 according to an embodiment of this application. The terminal 1 may be a base station, and the base station may include a baseband processing unit 101 and a transmitter 102. The transmitter 102 may include a radio frequency signal generation circuit 1021, a power amplifier 1022, a filter 1023, and an antenna 1024.

The baseband processing unit 101 is configured to generate a baseband digital signal.

The radio frequency signal generation circuit 1021 is configured to process the baseband digital signal, to obtain a radio frequency signal.

The power amplifier 1022 is configured to perform power amplification on the radio frequency signal.

The filter 1023 is configured to perform filtering processing on a power-amplified radio frequency signal, to obtain a to-be-transmitted signal.

The antenna 1024 is configured to transmit the to-be-transmitted signal.

FIG. 2 shows a circuit diagram of the foregoing power amplifier 1022. The power amplifier 1022 includes a direct current input end Vgate, a radio frequency input end RF In, a voltage end VDD, a transistor, and an output end RF Out.

An example in which the transistor is an N-type transistor and the radio frequency signal is a sine wave is used. A gate Gate of the transistor receives a direct current signal input through the direct current input end Vgate and the radio frequency signal input through the radio frequency input end RF In. When the radio frequency signal is positive, the transistor is connected, and the voltage end VDD is grounded through the transistor; and when the radio frequency signal is negative, the transistor is cut off, the voltage end VDD is connected to the output end RF Out, and the power-amplified radio frequency signal is output through the output end RF Out.

As proposed in the background, currently, the source of the transistor is grounded, and may be grounded through the conductive wire. However, there is the parasitic inductance on the conductive wire. As a result, the parasitic inductance of the source is increased, and the performance of the transistor deteriorates (where the gain is reduced). Alternatively, the source may be grounded through the back hole of the substrate. However, because space needs to be reserved for providing the back hole of the substrate in a chip design, the layout area of the chip is increased, and the costs are increased.

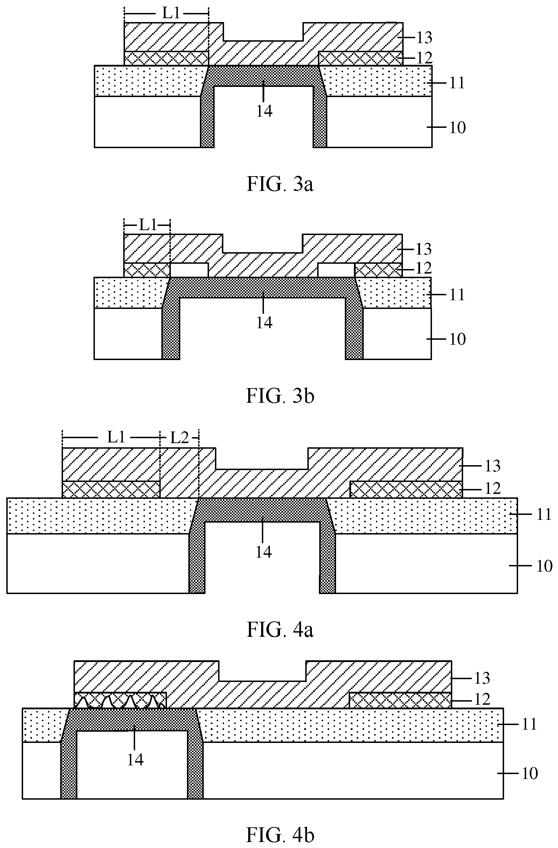

Specifically, as shown in FIG. 3a, the transistor includes an epitaxial layer 11, a source 12, and a first conducting layer 13 that are disposed on a substrate 10, and further includes a second conducting layer 14. A via may be formed on the substrate 10 and the epitaxial layer 11 along a direction from the substrate 10 to the epitaxial layer 11 through a back-side lithography process, and the second conducting layer 14 is disposed in the via, and is in contact with the first conducting layer 13. In this way, when the transistor is connected, the epitaxial layer 11 transmits a current to the source 12 along a direction from the epitaxial layer 11 to the source 12. Further, the source 12 transmits the current to the grounded second conducting layer 14 through the first conducting layer 13.

However, in a solution of a related technology, after the source 12 is formed, patterns of the substrate and the epitaxial layer 11 are obtained through etching by using the back-side lithography process. As shown in FIG. 3b, alignment precision of the back-side lithography process is excessively low (where a contact lithography machine is usually selected for the lithography process), and an alignment deviation is generally greater than or equal to 3 µm. When the epitaxial layer 11 is etched, the epitaxial layer 11 may be over-etched, and consequently, the epitaxial layer 11 cannot be in full contact with the source 12. In addition, as shown in FIG. 3b, the epitaxial layer 11 is usually etched by using a chlorine-based gas, and the chlorine-based gas also has etching effect on the source 12. Therefore, when the epitaxial layer 11 is etched, the source 12 may also be etched, and a length L1 of the source 12 becomes shorter. Consequently, the epitaxial layer 11 cannot be in full good contact with the source 12, and ohmic contact is abnormal. When the epitaxial layer 11 cannot be in full contact with the source 12, the epitaxial layer 11 may fail to transmit the current to the source 12.

It should be noted herein that, before the gate of the transistor is formed, a pattern of the source 12 is formed, and high-temperature annealing processing is performed on the source 12. Therefore, mutual capacitance can be implemented between the source 12 and the epitaxial layer 11, to form ohmic contact. The first conducting layer 13 is formed after the gate is formed. To avoid impact of an annealing process on the gate and a problem in controlling the epitaxial layer 11 by the gate, no annealing process is performed after a pattern of the first conducting layer 13 is formed. Therefore, even if the first conducting layer 13 is in contact with the epitaxial layer 11, mutual capacitance cannot be implemented between the first conducting layer 13 and the epitaxial layer 11 (where ohmic contact is formed). In other words, the epitaxial layer 11 cannot directly transmit the current to the first conducting layer 13.

As shown in FIG. 4a, to resolve a problem that the source 12 is partially damaged, the related technology proposes that the epitaxial layer 11 may protrude from the source 12, and a length of the epitaxial layer 11 protruding from the source 12 is L2. However, in this manner, a layout area of the transistor is increased, and especially, a plurality of transistors are generally connected in parallel on the chip, causing a great increase in the chip area. In addition, as shown in FIG. 4b, because the alignment precision of the back-side lithography process is low, a case in which the via of the epitaxial layer 11 is formed right below the source 12 still exists. Therefore, a case in which the source 12 is etched while the epitaxial layer 11 is etched still exists.

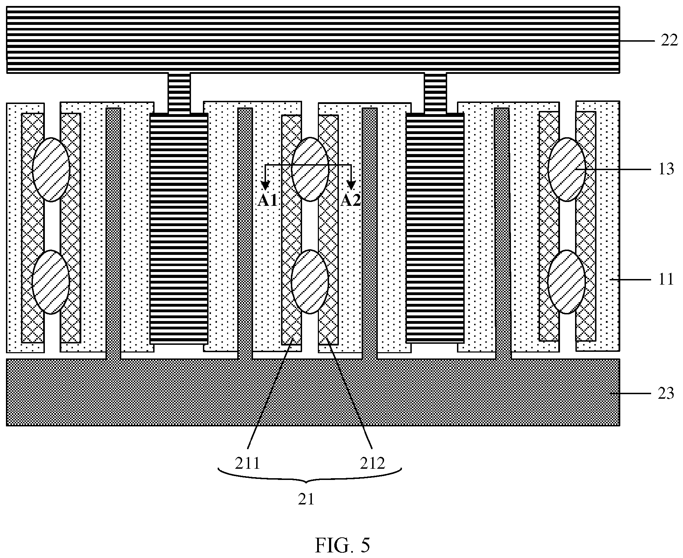

Based on the foregoing problems, an embodiment of this application provides a chip preparation method. As shown in FIG. 5, a plurality of transistors may be disposed on a chip, each transistor includes a source 211/212 and a drain 22, and the drain 22 may be disposed between the sources 211 and the sources 212 of two adjacent transistors, so that the two adjacent transistors share the same drain 22. The plurality of transistors may include a first transistor and a second transistor. The first transistor and the second transistor may be gallium nitride (gallium nitride, GaN) based high electron mobility transistors (high electron mobility transistors, HEMTs), gallium arsenide (gallium arsenide, GaAs) based pseudomorphic high electron mobility transistors (pseudomorphic high electron mobility transistors, PHEMTs), or the like.

In this application, a first epitaxial layer 101 of the first transistor and a second epitaxial layer 102 of the second transistor may be etched through a front-side lithography process. In other words, the first epitaxial layer 101 of the first transistor and the second epitaxial layer 102 of the second transistor may be etched along a direction from an epitaxial layer 11 to a substrate 10, to avoid impact of etching of the first epitaxial layer 101 and the second epitaxial layer 102 on a pattern of the source 12. In addition, layout areas occupied by the first transistor and the second transistor may be further reduced. Specifically, the transistor may be formed in the following two embodiments.

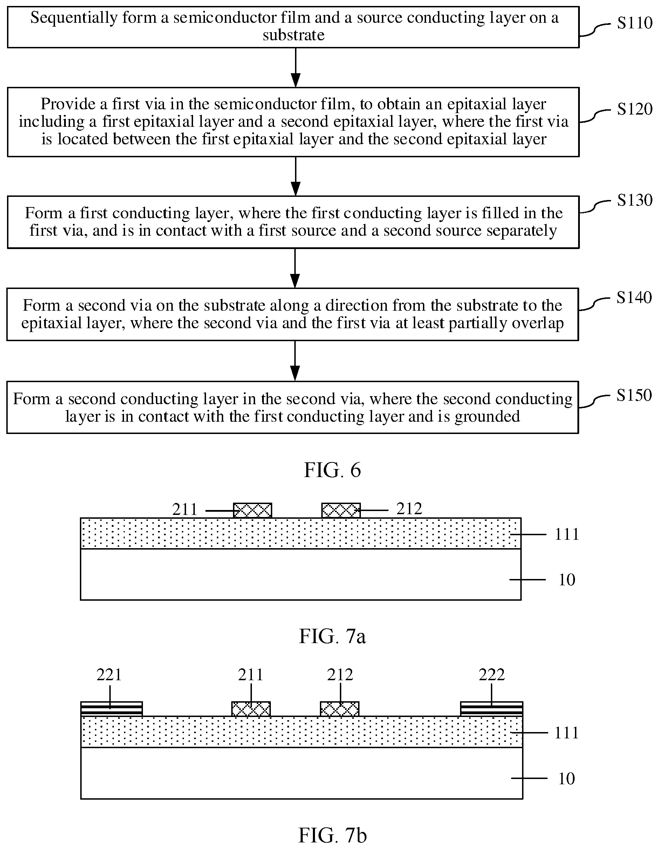

In an embodiment, as shown in FIG. 6, the step of forming the transistor may be implemented through the following steps.

S110: Sequentially form a semiconductor film 111 and a source conducting layer 21 on the substrate 10, as shown in FIG. 7a. The source conducting layer 21 includes the first source 211 and the second source 212 that are disposed at an interval. An example in which the chip includes the first transistor and the second transistor is used. The first source 211 may be used as a source 12 of the first transistor, and the second source 212 may be used as a source 12 of the second transistor.

In some possible implementations, a specific process of forming the semiconductor film 111 and the source conducting layer 21 may include: first sequentially forming the semiconductor film 111, a first conductive film, and a first photoresist on the substrate 10; then exposing the first photoresist, developing the first photoresist to obtain a first photoresist pattern, and etching the first conductive film under protection of the first photoresist pattern, to obtain a pattern of the source conducting layer 21; removing the first photoresist pattern; and performing high-temperature annealing processing on the pattern of the source conducting layer 21, to obtain the source conducting layer 21. It is clear that the source conducting layer 21 may alternatively be formed in another manner. This is not specially limited in this embodiment of this application.

In some possible implementations, as shown in FIG. 7b, when the source conducting layer 21 is formed, a first drain 221 of the first transistor and a second drain 222 of the second transistor may be further formed through a same semiconductor process, to omit a process of additionally forming the first drain 221 and the second drain 222, and save a mask (mask). The first drain 221 and the second drain 222 are disposed on a same layer as the first source 211 and the second source 212, the first drain 221 is disposed on a side of the first source 211 opposite to the second source 212, and the second drain 222 is disposed on a side of the second source 212 opposite to the first source 211.

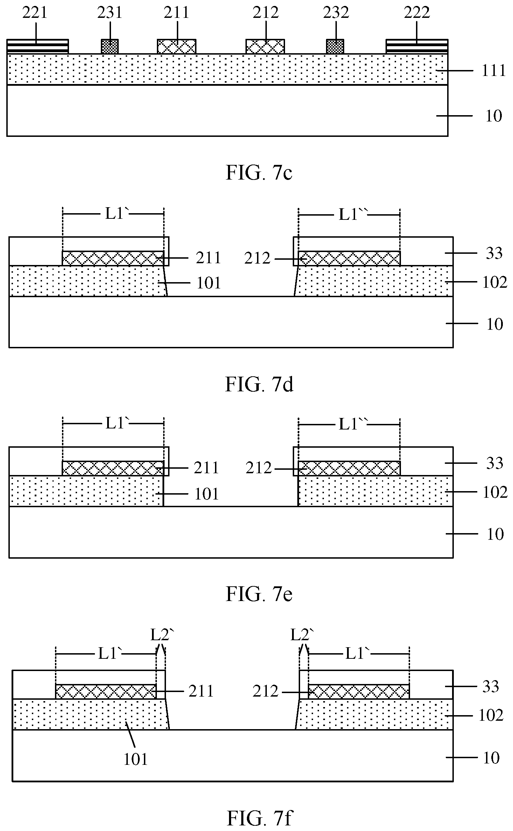

In some possible implementations, as shown in FIG. 7c, after step S110 and before step S120, a transistor preparation method may further include: forming a first gate 231 of the first transistor and a second gate 232 of the second transistor. Specifically, a specific process of forming the first gate 231 and the second gate 232 includes: sequentially forming a gate film and a second photoresist on a side of the semiconductor film 111 opposite to the substrate 10; exposing the second photoresist, developing the second photoresist to obtain a second photoresist pattern, and etching the gate film under protection of the second photoresist pattern, to obtain patterns of the first gate 231 and the second gate 232; removing the second photoresist pattern; and performing high-temperature annealing processing on the patterns of the first gate 231 and the second gate 232, to obtain the first gate 231 and the second gate 232. It is clear that the step of forming the first gate 231 and the second gate 232 may be performed between step S120 and step S130. This is not limited in this embodiment of this application.

As shown in FIG. 7c, the first gate 231 and the second gate 232 are disposed on the side of the semiconductor film 111 opposite to the substrate 10, the first gate 231 is disposed on the side of the first source 211 opposite to the second source 212, and the second gate 232 is disposed on the side of the second source 212 opposite to the first source 211.

In some possible implementations, the first source 211 and the second source 212 may have one layer, or may be stacked. Materials of the first source 211 and the second source 212 may include at least one of metals such as titanium (Ti), titanium nitride (TiN), aluminum (Al), nickel (Ni), platinum (Pt), palladium (Pd), chromium (Cr), and gold (Au). The materials of the first source 211 and the second source 212 may alternatively include a conductive oxide material such as indium tin oxide (indium tin oxide, ITO). Considering that the first source 211 and the second source 212 may be prepared through a same semiconductor process, the first source 211 and the second source 212 may have a same quantity of layers, and each layer of the first source 211 and the second source 212 has a same material.

S120: Provide a first via in the semiconductor film 111, to obtain the epitaxial layer 11 including the first epitaxial layer 101 and the second epitaxial layer 102, where the first via is located between the first epitaxial layer 101 and the second epitaxial layer 102, as shown in FIG. 7d. In addition, the first source 211 is disposed on a side of the first epitaxial layer 101 opposite to the substrate 10, and the second source 212 is disposed on a side of the second epitaxial layer 102 opposite to the substrate 10.

In some possible implementations, as shown in FIG. 7d, a specific process of providing the first via in the semiconductor film 111, to obtain the epitaxial layer 11 may include: forming a third photoresist on the side of the semiconductor film 111 opposite to the substrate 10; and exposing the third photoresist, developing the third photoresist to obtain a third photoresist pattern 33, and etching the semiconductor film 111 under protection of the third photoresist pattern 33, to obtain the epitaxial layer 11 including the first epitaxial layer 101, the second epitaxial layer 102, and the first via.

On this basis, after step S120 and before step S130, the chip preparation method may further include: stripping the third photoresist pattern 33.

In a possible implementation, although a commonly used chlorine-based gas has etching effect on materials of the epitaxial layer 11 and the source 12, because the semiconductor film is etched through the front-side lithography process in this application, and alignment precision of the front-side lithography process is very high, and is far higher than alignment precision of the back-side lithography process, the chlorine-based gas is not in contact with the first source 121 and the second source 122, and therefore does not affect patterns of the first source 121 and the second source 122, resulting in a case in which the first epitaxial layer 101 is not in full contact with the first source 121 and the second epitaxial layer 102 is not in full contact with the second source 122 when the semiconductor film 111 is etched by using the chlorine-based gas in a lithography manner of this application.

Based on this, in this application, the semiconductor film 111 may be etched along a direction from the source conducting layer 21 to the semiconductor film 111 by using the chlorine-based gas, to obtain the epitaxial layer 11 including the first epitaxial layer 101, the second epitaxial layer 102, and the first via. It is clear that the semiconductor film 111 may be etched by using another etching material. This is not limited in this embodiment of this application.

It should be noted herein that, as shown in FIG. 7d, the third photoresist pattern 33 may expose a part that is of the semiconductor film 111 and in which the first via is to be formed, and cover each exposed surface of the source conducting layer 21 and a part of the semiconductor film 111 other than the part in which the first via is to be formed, to avoid a case in which the source conducting layer 21 is incorrectly etched in a process of etching the semiconductor film 111 (especially in a process of etching the semiconductor film 111 by using the chlorine-based gas).

On this basis, in this application, the epitaxial layer 11 is formed through the front-side lithography process. To be specific, lithography is performed on the semiconductor film 111 along the direction from the source conducting layer 21 to the semiconductor film 111. In addition, the alignment precision of the front-side lithography process may be less than 100 nm, and is far higher than the alignment precision of the back-side lithography process. Therefore, when the semiconductor film 111 is etched, a case in which the source conducting layer 21 is incorrectly etched and the first epitaxial layer 101 and the second epitaxial layer 102 are over-etched due to a deviation of the lithography process is avoided, so that it can be ensured that the first epitaxial layer 101 is in full contact with the first source 211, and the second epitaxial layer 102 is in full contact with the second source 212. When the first transistor is connected, the first epitaxial layer 101 may effectively transmit a current to the first source 211, and the current is released to the ground through the first source 211. When the second transistor is connected, the second epitaxial layer 102 may effectively transmit a current to the second source 212, and the current is released to the ground through the second source 212.

In addition, in the first transistor and the second transistor that are formed in the foregoing steps S110 to S130, there may be the following several cases for a location relationship between the source conducting layer 21 and the epitaxial layer 11.

As shown in FIG. 7e, an edge that is of the first source 211 and that faces the second source 212 is flush with an edge of the first via close to the first source 211, and an edge that is of the second source 212 and that faces the first source 211 is flush with an edge of the first via close to the second source 212. In other words, an edge of the first source 211 is flush with an edge of the first epitaxial layer 101 close to a side of the first via, and an edge of the second source 212 is flush with an edge of the second epitaxial layer 102 close to a side of the first via. In addition, along a direction from the first source 211 to the second source 212, a length L1' of the first source 211 and a length L1" of the second source 212 are both equal to the length L1 of the source 12 in the related technology shown in FIG. 4a. However, in the solution of this application, the first epitaxial layer 101 does not need to protrude from the first source 211 along the direction from the first source 211 to the second source 212, and the second epitaxial layer 102 does not need to protrude from the second source 212 along a direction from the second source 212 to the first source 211. In other words, a length of the first epitaxial layer 101 protruding from the first source 211 is 0, and a length of the second epitaxial layer 102 protruding from the second source 212 is 0. Therefore, the layout areas occupied by the first transistor and the second transistor can be reduced, and a layout area of the entire chip is further reduced.

For example, along the direction from the first source 211 to the second source 212, both the length L1' of the first source 211 and the length L1" of the second source 212 are 8 µm. In the related technology shown in FIG. 4a, the length L2 of the epitaxial layer 11 protruding from the source 12 is 8 µm. Therefore, in comparison with the related technology, in the solution of this application, a layout of the source 12 occupied by one first transistor and one second transistor may be reduced by 2*L2=16 µm, and a reduction percentage is 50%.

In an alternative not forming part of the invention as claimed, as shown in FIG. 7f, in the source conducting layer 21 and the epitaxial layer 11 that are formed through the foregoing process, the first epitaxial layer 101 protrudes from the first source 211 along a direction from the first source 211 to the second source 212, and a length of a protruding part is L2'; and the second epitaxial layer 102 protrudes from the second source 212 along a direction from the second source 212 to the first source 211, and a length of a protruding part is L2'. However, in this application, the first epitaxial layer 101 and the second epitaxial layer 102 are formed through the front-side lithography process, and the alignment precision of the front-side lithography process is far higher than the alignment precision of the back-side lithography process. Therefore, in this application, the length L2' of the first epitaxial layer 101 protruding from the first source 211 and the length L2' of the second epitaxial layer 102 protruding from the second source 212 may be far less than the length L2 of the epitaxial layer 11 protruding from the source 12 in the related technology shown in FIG. 4a. Therefore, the layout areas occupied by the first transistor and the second transistor can be reduced, and the layout area of the entire chip is further reduced.

For example, along the direction from the first source 211 to the second source 212, both the length L1' of the first source 211 and the length L1" of the second source 212 are 8 µm. In the related technology shown in FIG. 4a, the length L2 of the epitaxial layer 11 protruding from the source 12 is 8 µm. However, in this application, the length L2' of the first epitaxial layer 101 protruding from the first source 211 and the length L2' of the second epitaxial layer 102 protruding from the second source 212 are both 1 µm. Therefore, in comparison with the related technology, in the solution of this application, a layout of the source 12 occupied by one first transistor and one second transistor may be reduced by 2*(L2-L2')=14 µm, and a reduction percentage is 44%.

Alternatively, due to a process reason, a tolerance may exist between the actually formed first epitaxial layer 101 and first source 211, and a tolerance may exist between the second epitaxial layer 102 and the second source 212. Therefore, in some possible implementations, as shown in FIG. 7d, a surface of the first epitaxial layer 101 opposite to the substrate 10 may also be flush with the edge of the first source 211, and a surface of the second epitaxial layer 102 opposite to the substrate 10 may also be flush with the edge of the second source 212. However, a surface that is of the first epitaxial layer 101 and that faces the substrate 10 may protrude from the edge of the first source 211, and a surface that is of the second epitaxial layer 102 and that faces the substrate 10 may protrude from the edge of the second source 212.

In some possible implementations, the first epitaxial layer 101 and the second epitaxial layer 102 may include a multi-layer structure. If the first transistor and the second transistor are the GaN based HEMTs, a material of the multi-layer structure may include AlₓGa_{y}N, where 0≤x≤1, 0≤y≤1, and x+y=1. If the first transistor and the second transistor are the GaAs based PHEMTs, a material of the multi-layer structure may include AlGaAs or high-purity GaAs. Considering that the first epitaxial layer 101 and the second epitaxial layer 102 may be prepared through a same semiconductor process, the first epitaxial layer 101 and the second epitaxial layer 102 may have a same quantity of layers, and each layer of the first epitaxial layer 101 and the second epitaxial layer 102 has a same material.

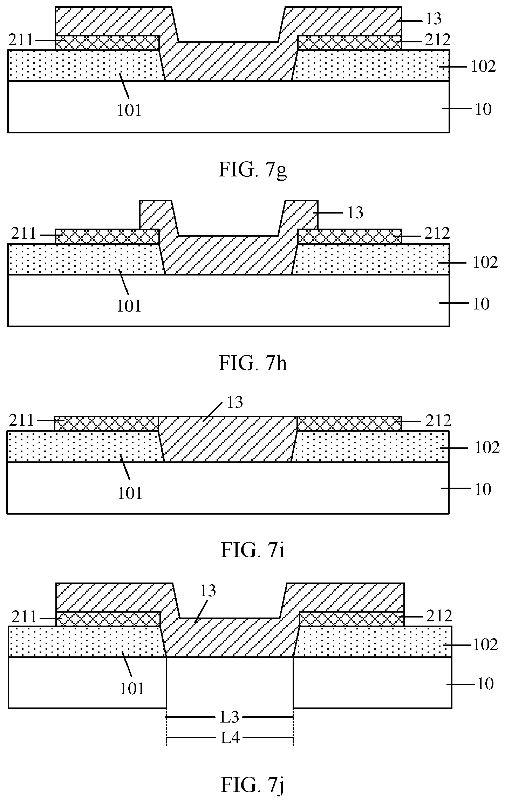

S130: Form a first conducting layer 13, as shown in FIG. 7g to FIG. 7i. The first conducting layer 13 is filled in the first via, and is in contact with the first source 211 and the second source 212 separately.

In some possible implementations, a specific process of forming the first conducting layer 13 may include: first sequentially forming a second conductive film and a fourth photoresist on a side of the source conducting layer 21 opposite to the substrate 10; then exposing the fourth photoresist, developing the fourth photoresist to obtain a fourth photoresist pattern, and etching the second conductive film under protection of the fourth photoresist pattern, to obtain the first conducting layer 13; and removing the fourth photoresist pattern. It is clear that the source conducting layer 21 may alternatively be formed in another manner. This is not specially limited in this embodiment of this application.

In some possible implementations, a specific location at which the first conducting layer 13 is disposed is not limited in this embodiment of this application, provided that the first conducting layer 13 is filled in the first via, and is in contact with the first source 211 and the second source 212 separately. Optionally, as shown in FIG. 7g, the first conducting layer 13 is filled in the first via, and completely covers a surface of the source conducting layer 21 opposite to the substrate 10. Alternatively, as shown in FIG. 7h, the first conducting layer 13 is filled in the first via, is disposed on the side of the source conducting layer 21 opposite to the substrate 10, and partially covers a surface of the source conducting layer 21 opposite to the substrate 10. Alternatively, as shown in FIG. 7i, the first conducting layer 13 is filled only in the first via, and is in contact with a side surface that is of the first source 211 and that faces the second source 212 and a side surface that is of the second source 212 and that faces the first source 211 separately. In comparison with the two solutions shown in FIG. 7h and FIG. 7i, in the solution shown in FIG. 7g, the first source 211 and the second source 212 may be in full contact with the first conducting layer 13, and a case in which the first conducting layer 13 is not in full contact with the first source 211 and/or the second source 212 due to a process error may be avoided.

In some possible implementations, the first conducting layer 13 may have one layer, or may be stacked. A material of the first conducting layer 13 may be a metal such as Ti, TiN, Al, Ni, Pt, Pd, Cr, or Au, or may be a conductive oxide material such as ITO.

S140: Form a second via on the substrate 10 along a direction from the substrate 10 to the epitaxial layer 11, as shown in FIG. 7j. The second via and the first via at least partially overlap.

In some possible implementations, the substrate 10 may be etched through the back-side lithography process, to obtain the second via. An example in which a material of the substrate 10 includes silicon carbide (SiC) or silicon (Si) is used. The substrate 10 may be etched by using a fluorine-based gas, to obtain the second via. Because the fluorine-based gas has high etching selectivity for a material of the epitaxial layer 11, the material of the first conducting layer 13, and a material of a second conducting layer 14 to be formed, the fluorine-based gas may stay on a surface of the second via. This does not affect forming of the second conducting layer 14 in subsequent step S150, or affect patterns of the first epitaxial layer 101, the second epitaxial layer 102, and the first conducting layer 13 that have been formed, and therefore does not affect normal contact between the second conducting layer 14 and the first conducting layer 13 subsequently.

In some possible implementations, a specific location of the second via is not limited in this embodiment of this application, provided that it can be ensured that the second conducting layer 14 filled in the second via can be in contact with the first conducting layer 13. The location of the second via is related to the second conducting layer 14 to be formed. When the second conducting layer 14 is described in step S150, the location of the second via is described in detail.

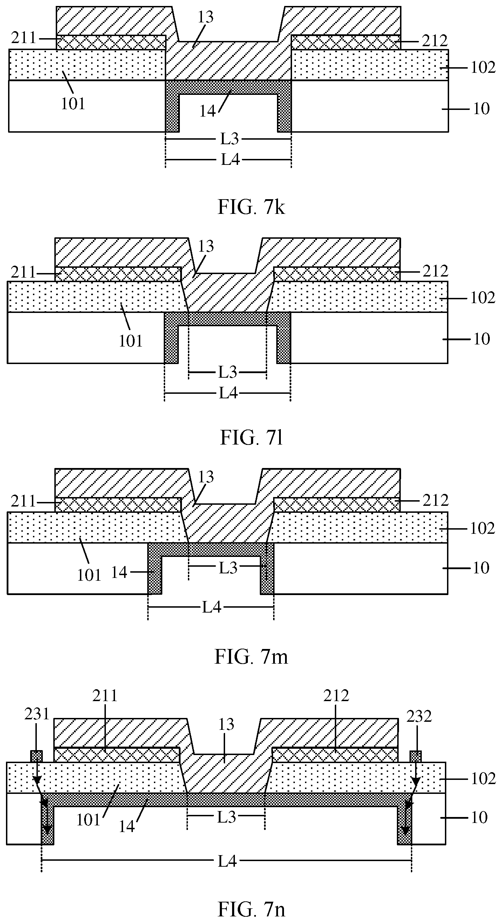

S150: Form the second conducting layer 14 in the second via, as shown in FIG. 7k to FIG. 7o. The second conducting layer 14 is in contact with the first conducting layer 13 and is grounded. In this way, the current sequentially transmitted by the first epitaxial layer 101 to the first source 211 and the first conducting layer 13 and the current sequentially transmitted by the second epitaxial layer 102 to the second source 212 and the first conducting layer 13 may be transmitted to the second conducting layer 14 and released to the ground.

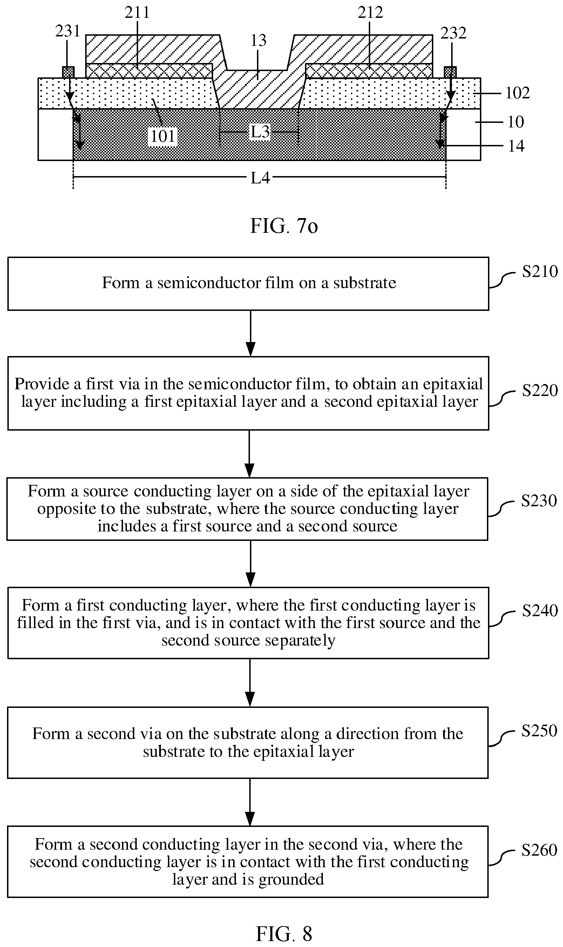

In some possible implementations, as shown in FIG. 7k to FIG. 7n, the second conducting layer 14 may be formed in the second via through an electroplating process. Along the direction from the substrate 10 to the epitaxial layer 11, a thickness of the second conducting layer 14 is less than a depth of the second via, and the second conducting layer 14 extends from a side wall of the second via to a surface that is of the first conducting layer 13 and that faces the substrate 10. In addition, as shown in FIG. 7o, the second conducting layer 14 may be filled in the entire second via.

In some possible implementations, a specific location of the second conducting layer 14 relative to the first conducting layer 13 is not limited in this embodiment of this application, provided that the second conducting layer 14 and the first conducting layer 13 can be in contact.

In a first case, as shown in FIG. 7k, the first via and the second via are disposed oppositely, and the edge that is of the first source 211 and that faces the second source 212 is flush with an edge that is of the first epitaxial layer 101 and that faces the second epitaxial layer 102. In other words, the edge of the first source 211 is flush with the edge of the first epitaxial layer 101 close to the side of the first via, and the edge of the second source 212 is flush with the edge of the second epitaxial layer 102 close to the side of the first via, so that the second conducting layer 14 is in contact with the first conducting layer 13. In addition, along the direction from the first source 211 to the second source 212, a length L3 of the first via is the same as a length L4 of the second via. In this way, the second conducting layer 14 to be formed may be in full contact with the first conducting layer 13.

In a second case, as shown in FIG. 7l, the first via and the second via are disposed oppositely, so that the second conducting layer 14 is in contact with the first conducting layer 13. In addition, along the direction from the first source 211 to the second source 212, a length L3 of the first via is less than a length L4 of the second via. In this way the second conducting layer 14 to be formed may be in full contact with the first conducting layer 13. In addition, the length L3 of the first via may be reduced while the length L4 of the second via remains unchanged. This further reduces the layout areas occupied by the first transistor and the second transistor.

In a third case, as shown in FIG. 7m, the first via and the second via are not disposed oppositely, but the second conducting layer 14 is still in contact with the first conducting layer 13. In addition, along the direction from the first source 211 to the second source 212, a length L3 of the first via is less than a length L4 of the second via. In this way, the length L3 of the first via may be reduced while the length L4 of the second via remains unchanged. This further reduces the layout areas occupied by the first transistor and the second transistor.

In a fourth case, as shown in FIG. 7n and FIG. 7o, the first via and the second via may be disposed oppositely, or may not be disposed oppositely, and the second conducting layer 14 is in contact with the first conducting layer 13. In addition, orthographic projections of the source conducting layer 21 and the first via on the substrate 10 are within a range of the second via, and along the direction from the first source 211 to the second source 212, a total length L5 from an edge of the first source 211 opposite to the second source 212 to an edge of the second source 212 opposite to the first source 211 is less than a length L4 of the second via. In this way, the second conducting layer 14 to be formed may be in full contact with the first conducting layer 13. In addition, as shown in FIG. 5, FIG. 7n, and FIG. 7o, the first gate 231 is disposed on a side of the epitaxial layer 11 opposite to the substrate 10, the first gate 231 is located on the side of the first source 211 opposite to the second source 212, and the second gate 232 is located on the side of the second source 212 opposite to the first source 211. A material of the second conducting layer 14 may be a metal material, and a thermal conductivity of the metal material is higher than a thermal conductivity of the material of the substrate 10. Therefore, when the first gate 231 and the second gate 232 generate heat, the heat on the first gate 231 may be exported to the second conducting layer 14 through the first epitaxial layer 101, and the heat on the second gate 232 may be exported to the second conducting layer 14 through the second epitaxial layer 102 (where heat conduction paths are shown by straight lines with arrows in FIG. 7n and FIG. 7o), to avoid impact on performance of the transistor due to excessively high temperatures of the first gate 231 and the second gate 232.

For example, as shown in FIG. 7n, the first via and the second via are disposed oppositely, and along the direction from the first source 211 to the second source 212, both a length L' of the first source 211 and a length L" of the second source 212 are 8 µm, a length L3 of the first via is 8 µm, and a size L4 of the second via is 25 µm. In this case, the orthographic projections of the source conducting layer 21 and the first via on the substrate 10 are within the range of the second via, and the second via protrudes from the first source 211 and the second source 212 separately. In this way, heat of a gate 23 may be exported through the second conducting layer 14 filled in the second via.

In the fourth case, in comparison with the solution (FIG. 7n) in which the thickness of the second conducting layer 14 is less than the depth of the second via and the second conducting layer 14 extends from the side wall of the second via to the surface that is of the first conducting layer 13 and that faces the substrate 10, the solution (FIG. 7o) in which the second conducting layer 14 is filled in the entire second via has a better thermal conduction effect for the gate 23.

In addition, in the fourth case, the first via and the second via may be disposed oppositely, or may not be disposed oppositely. Along the direction from the first source 211 to the second source 212, the length L3 of the first via may be equal to the length L4 of the second via, or may be less than the length L4 of the second via.

It should be noted that, that the first via and the second via are disposed oppositely may also be understood as follows: A center of the first via and a center of the second via overlap.

In addition, the foregoing four cases are all applicable to the GaN based HEMT. For the GaAs based PHEMT, because the material of the substrate 10 and materials of the first epitaxial layer 101 and the second epitaxial layer 102 both include GaAs, when the substrate 10 is etched through the back-side lithography process, the first epitaxial layer 101 and the second epitaxial layer 102 may be incorrectly etched. Therefore, along the direction from the first source 211 to the second source 212, the size L4 of the second via on the substrate 10 should be less than or equal to the length L3 of the first via.

In another embodiment, as shown in FIG. 8, the step of forming the first transistor and the second transistor may be implemented through the following steps.

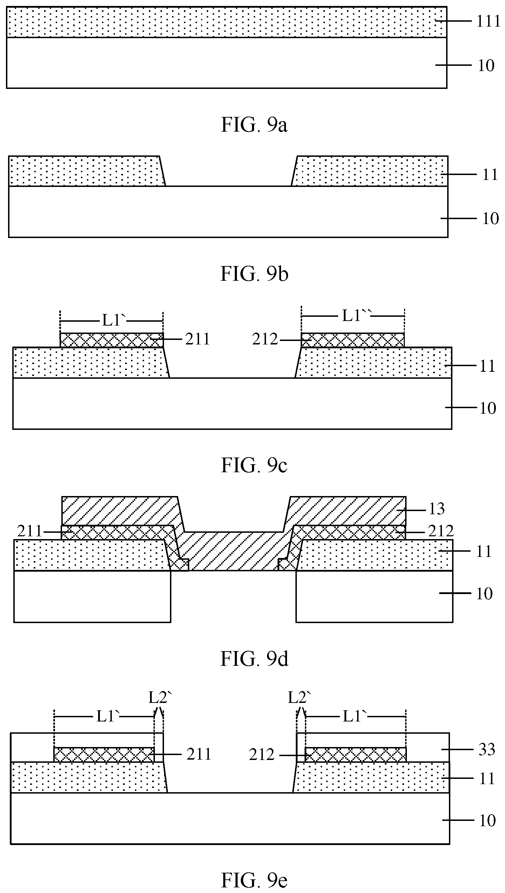

S210: Form a semiconductor film 111 on the substrate 10, as shown in FIG. 9a.

S220: Provide a first via in the semiconductor film 111, to obtain the epitaxial layer 11 including the first epitaxial layer 101 and the second epitaxial layer 102, as shown in FIG. 9b.

In some possible implementations, a specific process of providing the first via in the semiconductor film 111, to obtain the epitaxial layer 11 may include: forming a fifth photoresist on a side of the semiconductor film 111 opposite to the substrate 10; and exposing the fifth photoresist, developing the fifth photoresist to obtain a fifth photoresist pattern, and etching the semiconductor film 111 under protection of the fifth photoresist pattern, to obtain the epitaxial layer 11 including the first epitaxial layer 101, the second epitaxial layer 102, and the first via. Before step S230, the fifth photoresist pattern may be further stripped.

In a possible implementation, the semiconductor film 111 may be etched along a direction from the semiconductor film 111 to the substrate 10 by using a chlorine-based gas, to obtain the first epitaxial layer 101 and the second epitaxial layer 102. It is clear that the semiconductor film 111 may be etched by using another etching material. This is not limited in this embodiment of this application.

In some possible implementations, in this application, the first epitaxial layer 101 and the second epitaxial layer 102 are formed through the front-side lithography process. To be specific, lithography is performed on the semiconductor film 111 along a direction from a source conducting layer 21 to the semiconductor film 111. In addition, alignment precision of the front-side lithography process may be less than 100 nm, and is far higher than alignment precision of the back-side lithography process. Therefore, when the semiconductor film 111 is etched, a case in which the first epitaxial layer 101 and the second epitaxial layer 102 are over-etched due to a deviation of the lithography process is avoided, so that it can be ensured that the first epitaxial layer 101 is in full contact with the first source 211, and the second epitaxial layer 102 is in full contact with the second source 212. When the first transistor is connected, the first epitaxial layer 101 may effectively send a current to the first source 211, and the current is released to the ground through the first source 211. When the second transistor is connected, the second epitaxial layer 102 may effectively send a current to the second source 212, and the current is released to the ground through the second source 212.

In some possible implementations, the first epitaxial layer 101 and the second epitaxial layer 102 may include a multi-layer structure. If the first transistor and the second transistor are the GaN based HEMTs, a material of the multi-layer structure may include AlₓGa_{y}N, where 0≤x≤1, 0≤y≤1, and x+y=1. If the first transistor and the second transistor are the GaAs based PHEMTs, a material of the multi-layer structure may include AlGaAs or high-purity GaAs. Considering that the first epitaxial layer 101 and the second epitaxial layer 102 may be prepared through a same semiconductor process, the first epitaxial layer 101 and the second epitaxial layer 102 may have a same quantity of layers, and each layer of the first epitaxial layer 101 and the second epitaxial layer 102 has a same material.

S230: Form the source conducting layer 21 on a side of the epitaxial layer 11 opposite to the substrate 10, as shown in FIG. 9c and FIG. 9d. In other words, the first source 211 is formed on a side of the first epitaxial layer 101 opposite to the substrate 10, and the second source 212 is formed on a side of the second epitaxial layer 102 opposite to the substrate 10. An example in which the chip includes the first transistor and the second transistor is used. The first source 211 may be used as a source 12 of the first transistor, and the second source 212 may be used as a source 12 of the second transistor.

It should be noted herein that, because the first source 211 and the second source 212 are formed after step S220, the etching material for etching the semiconductor film 111 does not affect patterns of the first source 211 and the second source 212.

In some possible implementations, a specific process of forming the source conducting layer 21 may include: first sequentially forming a first conductive film and a first photoresist on the side of the first epitaxial layer 101 opposite to the substrate 10 and the side of the second epitaxial layer 102 opposite to the substrate 10; then exposing the first photoresist, developing the first photoresist to obtain a first photoresist pattern, and etching the first conductive film under protection of the first photoresist pattern, to obtain a pattern of the source conducting layer 21; removing the first photoresist pattern; and performing high-temperature annealing processing on the pattern of the source conducting layer 21, to obtain the first source 211 and the second source 212. It is clear that the first source 211 and the second source 212 may alternatively be formed in another manner. This is not specially limited in this embodiment of this application.

Refer to FIG. 7b. In some possible implementations, when the first source 211 and the second source 212 are formed, a first drain 221 of the first transistor and a second drain 222 of the second transistor may be further formed through a same semiconductor process, to omit a process of additionally forming the first drain 221 and the second drain 222, and save a mask. The first drain 221 and the second drain 222 are disposed on a same layer as the first source 211 and the second source 212, the first drain 221 is disposed on a side of the first source 211 opposite to the second source 212, and the second drain 222 is disposed on a side of the second source 212 opposite to the first source 211.

In some possible implementations, the first source 211 and the second source 212 may have one layer, or may be stacked. Materials of the first source 211 and the second source 212 may include at least one of metals such as Ti, TiN, Al, Ni, Pt, Pd, Cr, or Au. The materials of the first source 211 and the second source 212 may alternatively include a conductive oxide material such as ITO. Considering that the first source 211 and the second source 212 may be prepared through a same semiconductor process, the first source 211 and the second source 212 may have a same quantity of layers, and each layer of the first source 211 and the second source 212 has a same material.

Refer to FIG. 7c. In some possible implementations, after step S230 and before step S240, the transistor preparation method may further include: forming a first gate 231 of the first transistor and a second gate 232 of the second transistor. Specifically, a specific process of forming the first gate 231 and the second gate 232 includes: sequentially forming a gate film and a second photoresist on the side of the semiconductor film 111 opposite to the substrate 10; exposing the second photoresist, developing the second photoresist to obtain a second photoresist pattern, and etching the gate film under protection of the second photoresist pattern, to obtain patterns of the first gate 231 and the second gate 232; removing the second photoresist pattern; and performing high-temperature annealing processing on the patterns of the first gate 231 and the second gate 232, to obtain the first gate 231 and the second gate 232.

In the first transistor and the second transistor that are formed in the foregoing steps S210 to S230, there may be the following several cases for a location relationship between the source conducting layer 21 and the epitaxial layer 11.

Refer to FIG. 7e. An edge that is of the first source 211 and that faces the second source 212 may be flush with an edge of the first via close to the first source 211, and an edge that is of the second source 212 and that faces the first source 211 may be flush with an edge of the first via close to the second source 212. In other words, an edge of the first source 211 is flush with an edge of the first epitaxial layer 101 close to a side of the first via, and an edge of the second source 212 is flush with an edge of the second epitaxial layer 102 close to a side of the first via. In addition, along a direction from the first source 211 to the second source 212, a length L1' of the first source 211 and a length L1" of the second source 212 are both equal to the length L1 of the source 12 in the related technology shown in FIG. 4a. However, in the solution of this application, the first epitaxial layer 101 does not need to protrude from the first source 211 along the direction from the first source 211 to the second source 212, and the second epitaxial layer 102 does not need to protrude from the second source 212 along a direction from the second source 212 to the first source 211. In other words, a length of the first epitaxial layer 101 protruding from the first source 211 is 0, and a length of the second epitaxial layer 102 protruding from the second source 212 is 0. Therefore, the layout areas occupied by the first transistor and the second transistor can be reduced, and the layout area of the entire chip is further reduced.

For example, along the direction from the first source 211 to the second source 212, both the length L1' of the first source 211 and the length L1" of the second source 212 are 8 µm. In the related technology shown in FIG. 4a, the length L2 of the epitaxial layer 11 protruding from the source 12 is 8 µm. Therefore, in comparison with the related technology, in the solution of this application, a layout of the source 12 occupied by one first transistor and one second transistor may be reduced by 2*L2=16 µm, and a reduction percentage is 50%.

In an alternative not forming part of the invention as claimed, as shown in FIG. 9d, in the source conducting layer 21 and the epitaxial layer 11 that are formed through the foregoing process, the first source 211 protrudes from the first epitaxial layer 101 along a direction from the first source 211 to the second source 212; and the second source 212 protrudes from the second epitaxial layer 102 along a direction from the second source 212 to the first source 211. In other words, a part of the first source 211 and a part of the second source 212 further extend to the first via. In addition, in the solution of this application, the first epitaxial layer 101 does not need to protrude from the first source 211 along the direction from the first source 211 to the second source 212, and the second epitaxial layer 102 does not need to protrude from the second source 212 along the direction from the second source 212 to the first source 211. In other words, the length of the first epitaxial layer 101 protruding from the first source 211 is 0, and the length of the second epitaxial layer 102 protruding from the second source 212 is 0. Therefore, the layout areas occupied by the first transistor and the second transistor can be reduced, and the layout area of the entire chip is further reduced.

In an alternative not forming part of the invention as claimed, as shown in FIG. 9e, in the source conducting layer 21 and the epitaxial layer 11 that are formed through the foregoing process, the first epitaxial layer 101 protrudes from the first source 211 along the direction from the first source 211 to the second source 212, and a length of a protruding part is L2'; and the second epitaxial layer 102 protrudes from the second source 212 along the direction from the second source 212 to the first source 211, and a length of a protruding part is L2'. However, in this application, the epitaxial layer 11 is formed through the front-side lithography process, and lithography precision of the front-side lithography process is far higher than the alignment precision of the back-side lithography process. Therefore, in this application, the length L2' of the first epitaxial layer 101 protruding from the first source 211 and the length L2' of the second epitaxial layer 102 protruding from the second source 212 may be far less than the length L2 of the epitaxial layer 11 protruding from the source 12 in the related technology shown in FIG. 4a. Therefore, the layout areas occupied by the first transistor and the second transistor can be reduced, and the layout area of the entire chip is further reduced.

For example, along the direction from the first source 211 to the second source 212, both the length L1' of the first source 211 and the length L1" of the second source 212 are 8 µm. In the related technology shown in FIG. 4a, the length L2 of the epitaxial layer 11 protruding from the source 12 is 8 µm. However, in this application, the length L2' of the first epitaxial layer 101 protruding from the first source 211 and the length L2' of the second epitaxial layer 102 protruding from the second source 212 are both 1 µm. Therefore, in comparison with the related technology, in the solution of this application, a layout of the source 12 occupied by one first transistor and one second transistor may be reduced by 2*(L2-L2')=14 µm, and a reduction percentage is 44%.

Alternatively, due to a process reason, a tolerance may exist between the actually formed first epitaxial layer 101 and first source 211, and a tolerance may exist between the second epitaxial layer 102 and the second source 212. Therefore, in some possible implementations, as shown in FIG. 9c, a surface of the first epitaxial layer 101 opposite to the substrate 10 is flush with the edge of the first source 211, and a surface of the second epitaxial layer 102 opposite to the substrate 10 is flush with the edge of the second source 212. However, a surface that is of the first epitaxial layer 101 and that faces the substrate 10 may protrude from the edge of the first source 211, and a surface that is of the second epitaxial layer 102 and that faces the substrate 10 may protrude from the edge of the second source 212.

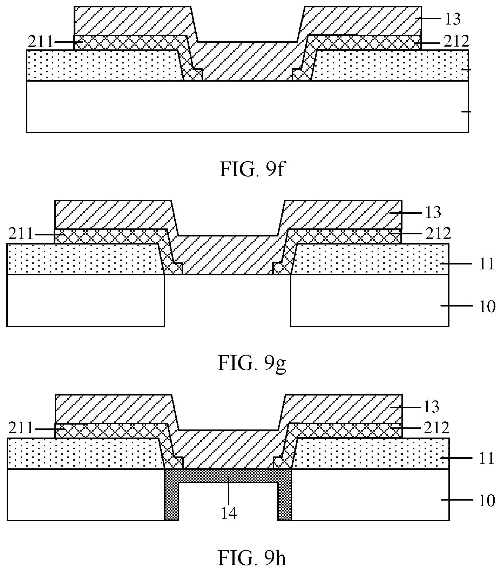

S240: Form a first conducting layer 13, as shown in FIG. 9f. The first conducting layer 13 is filled in the first via, and is in contact with the first source 211 and the second source 212 separately.

In some possible implementations, a specific process of forming the first conducting layer 13 may include: first sequentially forming a second conductive film and a fourth photoresist on a side of the source conducting layer 21 opposite to the substrate 10; then exposing the fourth photoresist, developing the fourth photoresist to obtain a fourth photoresist pattern, and etching the second conductive film under protection of the fourth photoresist pattern, to obtain the first conducting layer 13; and removing the fourth photoresist pattern. It is clear that the source conducting layer 21 may alternatively be formed in another manner. This is not specially limited in this embodiment of this application.

In some possible implementations, a specific location at which the first conducting layer 13 is disposed is not limited in this embodiment of this application, provided that the first conducting layer 13 is filled in the first via, and is in contact with the first source 211 and the second source 212 separately. Refer to FIG. 7f. Optionally, the first conducting layer 13 is filled in the first via, and completely covers a surface of the source conducting layer 21 opposite to the substrate 10. Refer to FIG. 7g. Alternatively, the first conducting layer 13 is filled in the first via, is disposed on the side of the source conducting layer 21 opposite to the substrate 10, and partially covers a surface of the source conducting layer 21 opposite to the substrate 10. Refer to FIG. 7h. Alternatively, the first conducting layer 13 is filled only in the first via, and is in contact with a side surface that is of the first source 211 and that faces the second source 212 and a side surface that is of the second source 212 and that faces the first source 211 separately. In comparison with the two solutions shown in FIG. 7g and FIG. 7h, in the solution shown in FIG. 7f, the first source 211 and the second source 212 may be in full contact with the first conducting layer 13, and a case in which the first conducting layer 13 is not in full contact with the first source 211 and/or the second source 212 due to a process error may be avoided.

In some possible implementations, the first conducting layer 13 may have one layer, or may be stacked. A material of the first conducting layer 13 may be a metal such as Ti, TiN, Al, Ni, Pt, Pd, Cr, or Au, or may be a conductive oxide material such as ITO.

S250: Form a second via on the substrate 10 along a direction from the substrate 10 to the epitaxial layer 11, as shown in FIG. 9g. The second via and the first via at least partially overlap.

In some possible implementations, the substrate 10 may be etched through the back-side lithography process, to obtain the second via. An example in which a material of the substrate 10 includes SiC or Si is used. The substrate 10 may be etched by using a fluorine-based gas, to obtain the second via. Because the fluorine-based gas has high etching selectivity for a material of the epitaxial layer 11, the material of the first conducting layer 13, and a material of a second conducting layer 14 to be formed, the fluorine-based gas may stay on a surface of the second via. This does not affect forming of the second conducting layer 14 in subsequent step S150, or affect patterns of the first epitaxial layer 101, the second epitaxial layer 102, and the first conducting layer 13 that have been formed, and therefore does not affect normal contact between the second conducting layer 14 and the first conducting layer 13 subsequently.

In some possible implementations, a specific location of the second via is not limited in this embodiment of this application, provided that it can be ensured that the second conducting layer 14 filled in the second via can be in contact with the first conducting layer 13. The location of the second via is related to the second conducting layer 14 to be formed. When the second conducting layer 14 is described in step S150, the location of the second via is described in detail.

S260: Form the second conducting layer 14 in the second via, as shown in FIG. 9h. The second conducting layer 14 is in contact with the first conducting layer 13 and is grounded. In this way, the current sequentially transmitted by the first epitaxial layer 101 to the first source 211 and the first conducting layer 13 and the current sequentially transmitted by the second epitaxial layer 102 to the second source 212 and the first conducting layer 13 may be transmitted to the second conducting layer 14 and released to the ground.

Refer to FIG. 7l to FIG. 7n. In some possible implementations, the second conducting layer 14 may be formed in the second via through an electroplating process. Along the direction from the substrate 10 to the epitaxial layer 11, a thickness of the second conducting layer 14 is less than a depth of the second via, and the second conducting layer 14 extends from a side wall of the second via to a surface that is of the first conducting layer 13 and that faces the substrate 10. Refer to FIG. 7o. In addition, the second conducting layer 14 may be filled in the entire second via.

In some possible implementations, a specific location of the second conducting layer 14 relative to the first conducting layer 13 is not limited in this embodiment of this application, provided that the second conducting layer 14 and the first conducting layer 13 can be in contact.

Refer to FIG. 7k. In a first case, the first via and the second via are disposed oppositely, and the edge that is of the first source 211 and that faces the second source 212 is flush with an edge that is of the first epitaxial layer 101 and that faces the second epitaxial layer 102. In other words, the edge of the first source 211 is flush with the edge of the first epitaxial layer 101 close to the side of the first via, and the edge of the second source 212 is flush with the edge of the second epitaxial layer 102 close to the side of the first via, so that the second conducting layer 14 is in contact with the first conducting layer 13. In addition, along the direction from the first source 211 to the second source 212, a length L3 of the first via is the same as a length L4 of the second via. In this way, the second conducting layer 14 to be formed may be in full contact with the first conducting layer 13.

Refer to FIG. 7l. In a second case, the first via and the second via are disposed oppositely, so that the second conducting layer 14 is in contact with the first conducting layer 13. In addition, along the direction from the first source 211 to the second source 212, a length L3 of the first via is less than a length L4 of the second via. In this way the second conducting layer 14 to be formed may be in full contact with the first conducting layer 13. In addition, the length L3 of the first via may be reduced while the length L4 of the second via remains unchanged. This further reduces the layout areas occupied by the first transistor and the second transistor.

Refer to FIG. 7m. In a third case, the first via and the second via are not disposed oppositely, but the second conducting layer 14 is still in contact with the first conducting layer 13. In addition, along the direction from the first source 211 to the second source 212, a length L3 of the first via is less than a length L4 of the second via. In this way, the length L3 of the first via may be reduced while the length L4 of the second via remains unchanged. This further reduces the layout areas occupied by the first transistor and the second transistor.

Refer to FIG. 7n and FIG. 7o. In a fourth case, the first via and the second via may be disposed oppositely, or may not be disposed oppositely, and the second conducting layer 14 is in contact with the first conducting layer 13. In addition, orthographic projections of the source conducting layer 21 and the first via on the substrate 10 are within a range of the second via, and along the direction from the first source 211 to the second source 212, a total length L5 from an edge of the first source 211 opposite to the second source 212 to an edge of the second source 212 opposite to the first source 211 is less than a length L4 of the second via. In this way, the second conducting layer 14 to be formed may be in full contact with the first conducting layer 13. In addition, as shown in FIG. 5, FIG. 7n, and FIG. 7o, the first gate 231 is disposed on the side of the epitaxial layer 11 opposite to the substrate 10, the first gate 231 is located on the side of the first source 211 opposite to the second source 212, and the second gate 232 is located on the side of the second source 212 opposite to the first source 211. A material of the second conducting layer 14 may be a metal material, and a thermal conductivity of the metal material is higher than a thermal conductivity of the material of the substrate 10. Therefore, when the first gate 231 and the second gate 232 generate heat, the heat on the first gate 231 may be exported to the second conducting layer 14 through the first epitaxial layer 101, and the heat on the second gate 232 may be exported to the second conducting layer 14 through the second epitaxial layer 102 (where heat conduction paths are shown by straight lines with arrows in FIG. 7n and FIG. 7o), to avoid impact on performance of the transistor due to excessively high temperatures of the first gate 231 and the second gate 232.

Refer to FIG. 7n. For example, the first via and the second via are disposed oppositely, and along the direction from the first source 211 to the second source 212, both a length L' of the first source 211 and a length L" of the second source 212 are 8 µm, a length L3 of the first via is 8 µm, and a size L4 of the second via is 25 µm. In this case, the orthographic projections of the source conducting layer 21 and the first via on the substrate 10 are within the range of the second via, and the second via protrudes from the first source 211 and the second source 212 separately. In this way, heat of a gate 23 may be exported through the second conducting layer 14 filled in the second via.

In the fourth case, in comparison with the solution (FIG. 7n) in which the thickness of the second conducting layer 14 is less than the depth of the second via and the second conducting layer 14 extends from the side wall of the second via to the surface that is of the first conducting layer 13 and that faces the substrate 10, the solution (FIG. 7o) in which the second conducting layer 14 is filled in the entire second via has a better thermal conduction effect for the gate 23.

In addition, in the fourth case, the first via and the second via may be disposed oppositely, or may not be disposed oppositely. Along the direction from the first source 211 to the second source 212, the length L3 of the first via may be equal to the length L4 of the second via, or may be less than the length L4 of the second via.

In addition, the foregoing four cases are all applicable to the GaN based HEMT. For the GaAs based PHEMT, because the material of the substrate 10 and materials of the first epitaxial layer 101 and the second epitaxial layer 102 both include GaAs, when the substrate 10 is etched through the back-side lithography process, the first epitaxial layer 101 and the second epitaxial layer 102 may be incorrectly etched. Therefore, along the direction from the first source 211 to the second source 212, the size L4 of the second via on the substrate 10 should be less than or equal to the length L3 of the first via.

In still another embodiment, an embodiment of this application further provides a chip. As shown in FIG. 5, the chip includes a substrate 10 and a first transistor and a second transistor that are disposed on the substrate 10. As shown in FIG. 7j and FIG. 9h, the first transistor includes a first epitaxial layer and a first source 211 that are sequentially disposed in a stacked manner, and the second transistor includes a second epitaxial layer and a second source 212 that are sequentially disposed in the stacked manner. The first epitaxial layer is disposed between the substrate 10 and the first source 211, the second epitaxial layer is disposed between the substrate 10 and the second source 212, and there is a first via between the first epitaxial layer 101 and the second epitaxial layer 102. An edge of the first source 211 is flush with an edge of the first epitaxial layer 101 close to a side of the first via, and an edge of the second source 212 is flush with an edge of the second epitaxial layer 102 close to a side of the first via.

On this basis, the chip may further include a first conducting layer 13 and a second conducting layer 14. The first conducting layer 13 is in contact with the first source 211 and the second source 212 separately, and is filled in the first via between the first epitaxial layer and the second epitaxial layer. The substrate 10 includes a second via, the second conducting layer 14 is filled in the second via, and the second conducting layer 14 is in contact with the first conducting layer 13 and is grounded.

It should be noted herein that the chip may be prepared by using the chip preparation method provided in any one of the foregoing embodiments.

In some possible implementations, the first source 211 and the second source 212 may have one layer, or may be stacked. Materials of the first source 211 and the second source 212 may include at least one of metals such as Ti, TiN, Al, Ni, Pt, Pd, Cr, or Au, or may be a conductive oxide material such as ITO. If the first source 211 and the second source 212 are prepared by using the chip preparation method in the foregoing embodiments, the first source 211 and the second source 212 may be prepared through a same semiconductor process. The first source 211 and the second source 212 may have a same quantity of layers, and each layer of the first source 211 and the second source 212 has a same material.

In some possible implementations, the first epitaxial layer and the second epitaxial layer are obtained through etching through a front-side lithography process, which is the same as the first source 211 and the second source 212. However, alignment precision of the front-side lithography process may be less than 100 nm, and is far higher than alignment precision of a back-side lithography process. Therefore, when a semiconductor film 111 is etched, a case in which a source conducting layer 21 is incorrectly etched and the first epitaxial layer 101 and the second epitaxial layer 102 are over-etched due to a deviation of the lithography process is avoided, so that it can be ensured that the first epitaxial layer 101 is in full contact with the first source 211, and the second epitaxial layer 102 is in full contact with the second source 212. When the first transistor is connected, the first epitaxial layer 101 may effectively transmit a current to the first source 211, and the current is released to the ground through the first source 211. When the second transistor is connected, the second epitaxial layer 102 may effectively transmit a current to the second source 212, and the current is released to the ground through the second source 212.

In addition, in the first transistor and the second transistor that are formed by using the foregoing method, there may be the following several cases for a location relationship between the source conducting layer 21 and an epitaxial layer 11.

As shown in FIG. 7e, an edge that is of the first source 211 and that faces the second source 212 may be flush with an edge of the first via close to the first source 211, and an edge that is of the second source 212 and that faces the first source 211 may be flush with an edge of the first via close to the second source 212. In other words, an edge of the first source 211 is flush with an edge of the first epitaxial layer 101 close to a side of the first via, and an edge of the second source 212 is flush with an edge of the second epitaxial layer 102 close to a side of the first via. In addition, along a direction from the first source 211 to the second source 212, a length L1' of the first source 211 and a length L1" of the second source 212 are both equal to the length L1 of the source 12 in the related technology shown in FIG. 4a. However, in the solution of this application, the first epitaxial layer 101 does not need to protrude from the first source 211 along the direction from the first source 211 to the second source 212, and the second epitaxial layer 102 does not need to protrude from the second source 212 along a direction from the second source 212 to the first source 211. In other words, a length of the first epitaxial layer 101 protruding from the first source 211 is 0, and a length of the second epitaxial layer 102 protruding from the second source 212 is 0. Therefore, layout areas occupied by the first transistor and the second transistor can be reduced, and a layout area of the entire chip is further reduced.

For example, along the direction from the first source 211 to the second source 212, both the length L1' of the first source 211 and the length L1" of the second source 212 are 8 µm. In the related technology shown in FIG. 4a, the length L2 of the first epitaxial layer 101 protruding from the first source 211 is 8 µm, and the length L2 of the second epitaxial layer 102 protruding from the second source 212 is 8 µm. Therefore, in comparison with the related technology, in the solution of this application, a layout of the source 12 occupied by one first transistor and one second transistor may be reduced by 2*L2=16 µm, and a reduction percentage is 50%.

Alternatively, as shown in FIG. 7f, in the source conducting layer 21, the first epitaxial layer 101, and the second epitaxial layer 102 that are formed through the foregoing process, the first epitaxial layer 101 protrudes from the first source 211 along a direction from the first source 211 to the second source 212, and a length of a protruding part is L2'; and the second epitaxial layer 102 protrudes from the second source 212 along a direction from the second source 212 to the first source 211, and a length of a protruding part is L2'. However, in this application, the first epitaxial layer 101 and the second epitaxial layer 102 are formed through the front-side lithography process, and the alignment precision of the front-side lithography process is far higher than the alignment precision of the back-side lithography process. Therefore, in this application, the length L2' of the first epitaxial layer 101 protruding from the first source 211 and the length L2' of the second epitaxial layer 102 protruding from the second source 212 may be far less than the length L2 of the epitaxial layer 11 protruding from the source 12 in the related technology shown in FIG. 4a. Therefore, the layout areas occupied by the first transistor and the second transistor can be reduced, and the layout area of the entire chip is further reduced.

For example, along the direction from the first source 211 to the second source 212, both the length L1' of the first source 211 and the length L1" of the second source 212 are 8 µm. In the related technology shown in FIG. 4a, both the length L2 of the first epitaxial layer 101 protruding from the first source 211 and the length L2 of the second epitaxial layer 102 protruding from the second source 212 are 8 µm. However, in this application, the length L2' of the first epitaxial layer 101 protruding from the first source 211 and the length L2' of the second epitaxial layer 102 protruding from the second source 212 are both 1 µm. Therefore, in comparison with the related technology, in the solution of this application, a layout of the source 12 occupied by one first transistor and one second transistor may be reduced by 2*(L2-L2')=14 µm, and a reduction percentage is 44%.

In an alternative not forming part of the invention as claimed, as shown in FIG. 9d, in the source conducting layer 21 and the epitaxial layer 11 that are formed through the foregoing process, the first source 211 protrudes from the first epitaxial layer 101 along the direction from the first source 211 to the second source 212; and the second source 212 protrudes from the second epitaxial layer 102 along the direction from the second source 212 to the first source 211. In addition, in the solution of this application, the first epitaxial layer 101 does not need to protrude from the first source 211 along the direction from the first source 211 to the second source 212, and the second epitaxial layer 102 does not need to protrude from the second source 212 along the direction from the second source 212 to the first source 211. In other words, the length of the first epitaxial layer 101 protruding from the first source 211 is 0, and the length of the second epitaxial layer 102 protruding from the second source 212 is 0. Therefore, the layout areas occupied by the first transistor and the second transistor can be reduced, and the layout area of the entire chip is further reduced.

Alternatively, due to a process reason, a tolerance may exist between the actually formed first epitaxial layer 101 and first source 211, and a tolerance may exist between the second epitaxial layer 102 and the second source 212. Therefore, in some possible implementations, as shown in FIG. 7d, a surface of the first epitaxial layer 101 opposite to the substrate 10 may also be flush with the edge of the first source 211, and a surface of the second epitaxial layer 102 opposite to the substrate 10 may also be flush with the edge of the second source 212. However, a surface that is of the first epitaxial layer 101 and that faces the substrate 10 may protrude from the edge of the first source 211, and a surface that is of the second epitaxial layer 102 and that faces the substrate 10 may protrude from the edge of the second source 212.

In some possible implementations, the first epitaxial layer 101 and the second epitaxial layer 102 may include a multi-layer structure. If the first transistor and the second transistor are the GaN based HEMTs, a material of the multi-layer structure may include AlₓGa_{y}N, where 0≤x≤1, 0≤y≤1, and x+y=1. If the first transistor and the second transistor are the GaAs based PHEMTs, a material of the multi-layer structure may include AlGaAs or high-purity GaAs. Considering that the first epitaxial layer 101 and the second epitaxial layer 102 may be prepared through a same semiconductor process, the first epitaxial layer 101 and the second epitaxial layer 102 may have a same quantity of layers, and each layer of the first epitaxial layer 101 and the second epitaxial layer 102 has a same material.

In some possible implementations, a specific location at which the first conducting layer 13 is disposed is not limited in this embodiment of this application, provided that the first conducting layer 13 is filled in the first via, and is in contact with the first source 211 and the second source 212 separately. Optionally, as shown in FIG. 7g, the first conducting layer 13 is filled in the first via, and completely covers a surface of the source conducting layer 21 opposite to the substrate 10. Alternatively, as shown in FIG. 7h, the first conducting layer 13 is filled in the first via, is disposed on a side of the source conducting layer 21 opposite to the substrate 10, and partially covers a surface of the source conducting layer 21 opposite to the substrate 10. Alternatively, as shown in FIG. 7i, the first conducting layer 13 is filled only in the first via, and is in contact with a side surface that is of the first source 211 and that faces the second source 212 and a side surface that is of the second source 212 and that faces the first source 211 separately. In comparison with the two solutions shown in FIG. 7h and FIG. 7i, in the solution shown in FIG. 7g, the first source 211 and the second source 212 may be in full contact with the first conducting layer 13, and a case in which the first conducting layer 13 is not in contact with the first source 211 and/or the second source 212 due to a process error may be avoided.

In some possible implementations, the first conducting layer 13 may have one layer, or may be stacked. A material of the first conducting layer 13 may be a metal such as Ti, TiN, Al, Ni, Pt, Pd, Cr, or Au, or may be a conductive oxide material such as ITO.

In some possible implementations, a specific location of the second via is not limited in this embodiment of this application, provided that it can be ensured that the second conducting layer 14 filled in the second via can be in contact with the first conducting layer 13.

In some possible implementations, a specific location of the second conducting layer 14 relative to the first conducting layer 13 is not limited in this embodiment of this application, provided that the second conducting layer 14 and the first conducting layer 13 can be in contact.

In a first case, as shown in FIG. 7k, the first via and the second via are disposed oppositely, and the edge that is of the first source 211 and that faces the second source 212 is flush with an edge that is of the first epitaxial layer 101 and that faces the second epitaxial layer 102. In other words, the edge of the first source 211 is flush with the edge of the first epitaxial layer 101 close to the side of the first via, and the edge of the second source 212 is flush with the edge of the second epitaxial layer 102 close to the side of the first via, so that the second conducting layer 14 is in contact with the first conducting layer 13. In addition, along the direction from the first source 211 to the second source 212, a length L3 of the first via is the same as a length L4 of the second via. In this way, the second conducting layer 14 to be formed may be in full contact with the first conducting layer 13.

In a second case, as shown in FIG. 7l, the first via and the second via are disposed oppositely, so that the second conducting layer 14 is in contact with the first conducting layer 13. In addition, along the direction from the first source 211 to the second source 212, a length L3 of the first via is less than a length L4 of the second via. In this way the second conducting layer 14 to be formed may be in full contact with the first conducting layer 13. In addition, the length L3 of the first via may be reduced while the length L4 of the second via remains unchanged. This further reduces the layout areas occupied by the first transistor and the second transistor.

In a third case, as shown in FIG. 7m, the first via and the second via are not disposed oppositely, but the second conducting layer 14 is still in contact with the first conducting layer 13. In addition, along the direction from the first source 211 to the second source 212, a length L3 of the first via is less than a length L4 of the second via. In this way, the length L3 of the first via may be reduced while the length L4 of the second via remains unchanged. This further reduces the layout areas occupied by the first transistor and the second transistor.

In a fourth case, as shown in FIG. 7n and FIG. 7o, the first via and the second via may be disposed oppositely, or may not be disposed oppositely, and the second conducting layer 14 is in contact with the first conducting layer 13. In addition, orthographic projections of the source conducting layer 21 and the first via on the substrate 10 are within a range of the second via, and along the direction from the first source 211 to the second source 212, a total length L5 from an edge of the first source 211 opposite to the second source 212 to an edge of the second source 212 opposite to the first source 211 is less than the length L4 of the second via. In this way, the second conducting layer 14 to be formed may be in full contact with the first conducting layer 13. In addition, as shown in FIG. 5, FIG. 7n, and FIG. 7o, a first gate 231 is disposed on a side of the epitaxial layer 11 opposite to the substrate 10, the first gate 231 is located on a side of the first source 211 opposite to the second source 212, and a second gate 232 is located on a side of the second source 212 opposite to the first source 211. A material of the second conducting layer 14 may be a metal material, and a thermal conductivity of the metal material is higher than a thermal conductivity of a material of the substrate 10. Therefore, when the first gate 231 and the second gate 232 generate heat, the heat on the first gate 231 may be exported to the second conducting layer 14 through the first epitaxial layer 101, and the heat on the second gate 232 may be exported to the second conducting layer 14 through the second epitaxial layer 102 (where heat conduction paths are shown by straight lines with arrows in FIG. 7n and FIG. 7o), to avoid impact on performance of the transistor due to excessively high temperatures of the first gate 231 and the second gate 232.

For example, as shown in FIG. 7n, the first via and the second via are disposed oppositely, and along the direction from the first source 211 to the second source 212, both a length L' of the first source 211 and a length L" of the second source 212 are 8 µm, a length L3 of the first via is 8 µm, and a size L4 of the second via is 25 µm. In this case, the orthographic projections of the source conducting layer 21 and the first via on the substrate 10 are within the range of the second via, and the second via protrudes from the first source 211 and the second source 212 separately. In this way, heat of a gate 23 may be exported through the second conducting layer 14 filled in the second via.

In the fourth case, in comparison with the solution (FIG. 7n) in which a thickness of the second conducting layer 14 is less than a depth of the second via and the second conducting layer 14 extends from a side wall of the second via to a surface that is of the first conducting layer 13 and that faces the substrate 10, the solution (FIG. 7o) in which the second conducting layer 14 is filled in the entire second via has a better thermal conduction effect for a gate 23.

In addition, in the fourth case, the first via and the second via may be disposed oppositely, or may not be disposed oppositely. In addition, along the direction from the first source 211 to the second source 212, the length L3 of the first via may be equal to the length L4 of the second via, or may be less than the length L4 of the second via.

In addition, the foregoing four cases are all applicable to the GaN based HEMT. For the GaAs based PHEMT, because the material of the substrate 10 and materials of the first epitaxial layer 101 and the second epitaxial layer 102 both include GaAs, when the substrate 10 is etched through the back-side lithography process, the first epitaxial layer 101 and the second epitaxial layer 102 may be incorrectly etched. Therefore, along the direction from the first source 211 to the second source 212, the size L4 of the second via on the substrate 10 should be less than or equal to the length L3 of the first via.

In addition, other explanations, descriptions, and beneficial effects of this embodiment of this application are the same as those of the foregoing two embodiments, and details are not described herein again.

The foregoing describes embodiments of this application with reference to the accompanying drawings. However, this application is not limited to the foregoing specific implementations. The foregoing specific implementations are merely examples, but are not limitative.

## Claims

1. A chip preparation method, wherein a chip comprises a first transistor and a second transistor, and the chip preparation method comprises:
forming, on a substrate (10), an epitaxial layer (111) and a source conducting layer (211, 212) that are sequentially disposed in a stacked manner, wherein the epitaxial layer comprises a first via, to form a first epitaxial layer (101) of the first transistor and a second epitaxial layer (102) of the second transistor; the source conducting layer comprises a first source (211) of the first transistor and a second source (212) of the second transistor, the first source is disposed on a side of the first epitaxial layer opposite to the substrate, and the second source is disposed on a side of the second epitaxial layer opposite to the substrate; and an edge of the first source is flush with an edge of the first epitaxial layer close to a side of the first via, and an edge of the second source is flush with an edge of the second epitaxial layer close to a side of the first via;
forming a first conducting layer (13), wherein the first conducting layer is at least filled in the first via, and is in contact with the first source and the second source separately;
forming a second via in the substrate, wherein the second via and the first via at least partially overlap; and
forming a second conducting layer (14), wherein the second conducting layer is located in the second via, and the second conducting layer is in contact with the first conducting layer and is grounded.

2. The chip preparation method according to claim 1, wherein the forming, on a substrate, an epitaxial layer and a source conducting layer that are sequentially disposed in a stacked manner comprises:
sequentially forming a semiconductor film and the source conducting layer on the substrate; and
providing the first via in the semiconductor film, to obtain the epitaxial layer.

3. The chip preparation method according to claim 1, wherein the forming, on a substrate, an epitaxial layer and a source conducting layer that are sequentially disposed in a stacked manner comprises:
forming a semiconductor film on the substrate;
providing the first via in the semiconductor film, to obtain the epitaxial layer; and
forming the source conducting layer on a side of the epitaxial layer opposite to the substrate.

4. The chip preparation method according to claim 2 or 3, wherein the providing the first via in the semiconductor film, to obtain the epitaxial layer comprises:
forming a photoresist (33) on a side of the semiconductor film opposite to the substrate;
exposing the photoresist, and developing the photoresist to obtain a photoresist pattern; and
etching the semiconductor film along a direction from the epitaxial layer to the substrate, to obtain the epitaxial layer.

5. The chip preparation method according to claim 4, wherein alignment precision of etching the semiconductor film is less than 100 nm.

6. The chip preparation method according to claim 5, wherein the etching the semiconductor film, to obtain the epitaxial layer comprises:
etching the semiconductor film by using a chlorine-based gas, to obtain the epitaxial layer.

7. The chip preparation method according to any one of claims 1 to 6, wherein the forming a second via on the substrate comprises:
etching the substrate along a direction from the substrate to the epitaxial layer, to obtain the second via.

8. The chip preparation method according to any one of claims 1 to 7, wherein along a direction from the first source to the second source, a size of the first via is less than a size of the second via.

9. The chip preparation method according to claim 8, wherein orthographic projections of the source conducting layer and the first via on the substrate are within a range of the second via, and along the direction from the first source to the second source, a total length from an edge of the first source opposite to the second source to an edge of the second source opposite to the first source is less than the size of the second via; and
before the forming a second conducting layer, a transistor preparation method further comprises:
forming a first gate (231) of the first transistor and a second gate (232) of the second transistor on the side of the epitaxial layer opposite to the substrate, wherein the first gate is located on a side of the first source opposite to the second source, and the second gate is located on a side of the second source opposite to the first source.

10. The chip preparation method according to any one of claims 1 to 7, wherein along a direction from the first source to the second source, a size of the first via is greater than or equal to a size of the second via.

11. The chip preparation method according to any one of claims 8 to 10, wherein a center of the first via and a center of the second via overlap.

12. A chip, comprising a substrate (10) and a first transistor and a second transistor that are disposed on the substrate, wherein
the first transistor comprises a first epitaxial layer (101) and a first source (211) that are sequentially disposed on the substrate in a stacked manner, the second transistor comprises a second epitaxial layer (102) and a second source (212)
that are sequentially disposed on the substrate in the stacked manner, and a first via is provided between the first epitaxial layer and the second epitaxial layer; an edge of the first source is flush with an edge of the first epitaxial layer close to a side of the first via, and an edge of the second source is flush with an edge of the second epitaxial layer close to a side of the first via; and the chip further comprises a first conducting layer (13), wherein the first conducting layer is in contact with the first source and the second source separately, and is filled in the first via; and
the substrate comprises a second via, and the chip further comprises a second conducting layer (14), wherein the second conducting layer is filled in the second via, and the second conducting layer is in contact with the first conducting layer and is grounded.

13. The chip according to claim 12, wherein along a direction from the first source to the second source, a size of the first via is less than a size of the second via.

14. The chip according to claim 13, wherein the first transistor further comprises a first gate, and the second transistor further comprises a second gate; the first gate is disposed on a side of the first epitaxial layer opposite to the substrate, and is located on a side of the first source opposite to the second source; and the second gate is disposed on a side of the second epitaxial layer opposite to the substrate, and is located on a side of the second source opposite to the first source; and
orthographic projections of the first source, the first via, and the second source on the substrate are within a range of the second via, and along the direction from the first source to the second source, a total length from an edge of the first source opposite to the second source to an edge of the second source opposite to the first source is less than the size of the second via.

15. The chip according to claim 12, wherein along a direction from the first source to the second source, a size of the first via is greater than or equal to a size of the second via.

## Patentansprüche

1. Verfahren zur Herstellung von Chips, wobei ein Chip einen ersten Transistor und einen zweiten Transistor umfasst, und das Verfahren zur Herstellung von Chips Folgendes umfasst:
Ausbilden einer Epitaxieschicht (111) und einer Source-leitenden Schicht (211, 212) auf einem Substrat (10), die sequenziell gestapelt angeordnet sind, wobei die Epitaxieschicht ein erstes Durchgangskontaktloch umfasst, um eine erste Epitaxieschicht (101) des ersten Transistors und eine zweite Epitaxieschicht (102) des zweiten Transistors auszubilden; die Source-leitende Schicht eine erste Source (211) des ersten Transistors und eine zweite Source (212) des zweiten Transistors umfasst, die erste Source auf einer Seite der ersten Epitaxieschicht gegenüber dem Substrat angeordnet ist und die zweite Source auf einer Seite der zweiten Epitaxieschicht gegenüber dem Substrat angeordnet ist; und eine Kante der ersten Source mit einer Kante der ersten Epitaxieschicht nahe einer Seite des ersten Durchgangskontaktlochs bündig ist und eine Kante der zweiten Source mit einer Kante der zweiten Epitaxieschicht nahe einer Seite des ersten Durchgangskontaktlochs bündig ist;
Ausbilden einer ersten leitenden Schicht (13), wobei die erste leitende Schicht mindestens in dem ersten Durchgangskontaktloch gefüllt ist und mit der ersten Source und der zweiten Source separat in Kontakt steht;
Ausbilden eines zweiten Durchgangskontaktlochs in dem Substrat, wobei sich das zweite Durchgangskontaktlochs und das erste Durchgangskontaktlochs mindestens teilweise überlappen; und
Ausbilden einer zweiten leitenden Schicht (14), wobei sich die zweite leitende Schicht in dem zweiten Durchgangskontaktloch befindet und die zweite leitende Schicht in Kontakt mit der ersten leitenden Schicht steht und geerdet ist.

2. Verfahren zur Herstellung von Chips nach Anspruch 1, wobei das Ausbilden einer Epitaxieschicht und einer Source-leitenden Schicht, die sequenziell gestapelt angeordnet sind, auf einem Substrat Folgendes umfasst:
sequenzielles Ausbilden eines Halbleiterfilms und der Source-leitenden Schicht auf dem Substrat; und
Bereitstellen des ersten Durchgangskontaktlochs in der Halbleiterschicht, um die Epitaxieschicht zu erlangen.

3. Verfahren zur Herstellung von Chips nach Anspruch 1, wobei das Ausbilden einer Epitaxieschicht und einer Source-leitenden Schicht, die nacheinander gestapelt angeordnet sind, auf einem Substrat Folgendes umfasst:
Ausbilden einer Halbleiterschicht auf dem Substrat;
Bereitstellen des ersten Durchgangskontaktlochs in der Halbleiterschicht, um die Epitaxieschicht zu erlangen; und
Ausbilden der Source-leitenden Schicht auf einer dem Substrat gegenüberliegenden Seite der Epitaxieschicht.

4. Verfahren zur Herstellung von Chips nach Anspruch 2 oder 3, wobei das Bereitstellen des ersten Durchgangskontaktlochs in der Halbleiterschicht, um die Epitaxieschicht zu erlangen, Folgendes umfasst:
Ausbilden eines Photoresists (33) auf einer dem Substrat gegenüberliegenden Seite des Halbleiterfilms;
Belichten des Photoresists und Entwickeln des Photoresists, um ein Photoresistmuster zu erlangen; und
Ätzen des Halbleiterfilms entlang einer Richtung von der Epitaxieschicht zu dem Substrat, um die Epitaxieschicht zu erlangen.

5. Verfahren zur Herstellung von Chips nach Anspruch 4, wobei die Ausrichtungsgenauigkeit des Ätzens der Halbleiterschicht weniger als 100 nm beträgt.

6. Verfahren zur Herstellung von Chips nach Anspruch 5, wobei das Ätzen des Halbleiterfilms, um die Epitaxieschicht zu erlangen, Folgendes umfasst:
Ätzen des Halbleiterfilms unter Verwendung eines Gases auf Chlorbasis, um die Epitaxieschicht zu erlangen.

7. Verfahren zur Herstellung von Chips nach einem der Ansprüche 1 bis 6, wobei das Ausbilden eines zweiten Durchgangskontaktlochs auf dem Substrat Folgendes umfasst:
Ätzen des Substrats entlang einer Richtung von dem Substrat zu der Epitaxieschicht, um das zweite Durchgangskontaktloch zu erlangen.

8. Verfahren zur Herstellung von Chips nach einem der Ansprüche 1 bis 7, wobei entlang einer Richtung von der ersten Source zu der zweiten Source eine Größe des ersten Durchgangskontaktlochs kleiner als eine Größe des zweiten Durchgangskontaktloch ist.

9. Verfahren zur Herstellung von Chips nach Anspruch 8, wobei orthographische Projektionen der Source-leitenden Schicht und des ersten Durchgangskontaktlochs auf dem Substrat innerhalb eines Bereichs des zweiten Durchgangskontaktlochs liegen und entlang der Richtung von der ersten Source zu der zweiten Source eine Gesamtlänge von einer Kante der ersten Source gegenüber der zweiten Source zu einer Kante der zweiten Source gegenüber der ersten Source kleiner als die Größe des zweiten Durchgangskontaktlochs ist; und
ein Verfahren zur Herstellung von Transistoren vor dem Ausbilden einer zweiten leitenden Schicht ferner Folgendes umfasst:
Ausbilden eines ersten Gates (231) des ersten Transistors und eines zweiten Gates (232) des zweiten Transistors auf der dem Substrat gegenüberliegenden Seite der Epitaxieschicht, wobei sich das erste Gate auf einer Seite der ersten Source gegenüber der zweiten Source befindet und sich das zweite Gate auf einer Seite der zweiten Source gegenüber der ersten Source befindet.

10. Verfahren zur Herstellung von Chips nach einem der Ansprüche 1 bis 7, wobei entlang einer Richtung von der ersten Source zu der zweiten Source eine Größe des ersten Durchgangskontaktlochs größer oder gleich einer Größe des zweiten Durchgangskontaktlochs ist.

11. Verfahren zur Herstellung von Chips nach einem der Ansprüche 8 bis 10, wobei sich die Mitte des ersten Durchgangskontaktlochs und die Mitte des zweiten Durchgangskontaktlochs überlappen.

12. Chip, umfassend ein Substrat (10) und einen ersten Transistor und einen zweiten Transistor, die auf dem Substrat angeordnet sind, wobei
der erste Transistor eine erste Epitaxieschicht (101) und eine erste Source (211) umfasst, die sequenziell gestapelt auf dem Substrat angeordnet sind, der zweite Transistor eine zweite Epitaxieschicht (102) und eine zweite Source (212) umfasst, die sequenziell gestapelt auf dem Substrat angeordnet sind, und ein erstes Durchgangskontaktloch zwischen der ersten Epitaxieschicht und der zweiten Epitaxieschicht bereitgestellt ist; eine Kante der ersten Source mit einer Kante der ersten Epitaxieschicht nahe einer Seite des ersten Durchgangskontaktlochs bündig ist und eine Kante der zweiten Source mit einer Kante der zweiten Epitaxieschicht nahe einer Seite des ersten Durchgangskontaktlochs bündig ist; und der Chip ferner eine erste leitende Schicht (13) umfasst,
wobei die erste leitende Schicht separat mit der ersten Source und der zweiten Source in Kontakt steht und in den ersten Durchgangskontaktloch gefüllt ist; und
das Substrat ein zweites Durchgangskontaktloch umfasst und der Chip ferner eine zweite leitende Schicht (14) umfasst,
wobei die zweite leitende Schicht in den zweiten Durchgangskontaktloch gefüllt ist und die zweite leitende Schicht in Kontakt mit der ersten leitenden Schicht steht und geerdet ist.

13. Chip nach Anspruch 12, wobei entlang einer Richtung von der ersten Source zu der zweiten Source eine Größe des ersten Durchgangskontaktlochs kleiner als eine Größe des zweiten Durchgangskontaktlochs ist.

14. Chip nach Anspruch 13, wobei der erste Transistor ferner ein erstes Gate umfasst und der zweite Transistor ferner ein zweites Gate umfasst; das erste Gate auf einer Seite der ersten Epitaxieschicht gegenüber dem Substrat angeordnet ist und sich auf einer Seite der ersten Source gegenüber der zweiten Source befindet; und das zweite Gate auf einer Seite der zweiten Epitaxieschicht gegenüber dem Substrat angeordnet ist und sich auf einer Seite der zweiten Source gegenüber der ersten Source befindet; und
orthographische Projektionen der ersten Source, das erste Durchgangskontaktloch und die zweite Source auf dem Substrat innerhalb eines Bereichs des zweiten Durchgangskontaktlochs liegen und entlang der Richtung von der ersten Source zu der zweiten Source eine Gesamtlänge von einer Kante der ersten Source gegenüber der zweiten Source zu einer Kante der zweiten Source gegenüber der ersten Source kleiner als die Größe des zweiten Durchgangskontaktlochs ist.

15. Chip nach Anspruch 12, wobei entlang einer Richtung von der ersten Source zu der zweiten Source eine Größe des ersten Durchgangskontaktlochs größer oder gleich einer Größe des zweiten Durchgangskontaktlochs ist.

## Revendications

1. Procédé de préparation de puce, dans lequel une puce comprend un premier transistor et un second transistor, et le procédé de préparation de puce comprend :
la formation, sur un substrat (10), d'une couche épitaxiale (111) et d'une couche conductrice de source (211, 212) qui sont disposées séquentiellement de manière empilée, dans lequel la couche épitaxiale comprend un premier via, pour former une première couche épitaxiale (101) du premier transistor et une seconde couche épitaxiale (102) du second transistor ; la couche conductrice de source comprend une première source (211) du premier transistor et une seconde source (212) du second transistor, la première source est disposée sur un côté de la première couche épitaxiale opposé au substrat, et la seconde source est disposée sur un côté de la seconde couche épitaxiale opposé au substrat ; et un bord de la première source affleure un bord de la première couche épitaxiale proche d'un côté du premier via, et un bord de la seconde source affleure un bord de la seconde couche épitaxiale proche d'un côté du premier via ;
la formation d'une première couche conductrice (13), dans lequel la première couche conductrice est au moins remplie dans le premier via, et est en contact avec la première source et la seconde source séparément ;
la formation d'un second via dans le substrat, dans lequel le second via et le premier via se chevauchent au moins partiellement ; et
la formation d'une seconde couche conductrice (14), dans lequel la seconde couche conductrice est située dans le second via, et la seconde couche conductrice est en contact avec la première couche conductrice et est mise à la terre.

2. Procédé de préparation de puce selon la revendication 1, dans lequel la formation, sur un substrat, d'une couche épitaxiale et d'une couche conductrice de source disposées séquentiellement de manière empilée comprend :
la formation séquentielle d'un film semi-conducteur et de la couche conductrice de source sur le substrat ; et
la fourniture du premier via dans le film semi-conducteur, pour obtenir la couche épitaxiale.

3. Procédé de préparation de puce selon la revendication 1, dans lequel la formation, sur un substrat, d'une couche épitaxiale et d'une couche conductrice de source disposées séquentiellement de manière empilée comprend :
la formation d'un film semi-conducteur sur le substrat ;
la fourniture du premier via dans le film semi-conducteur, pour obtenir la couche épitaxiale ; et
la formation de la couche conductrice de source sur un côté de la couche épitaxiale opposé au substrat.

4. Procédé de préparation de puce selon la revendication 2 ou 3, dans lequel la fourniture du premier via dans le film semi-conducteur, pour obtenir la couche épitaxiale, comprend :
la formation d'une résine photosensible (33) sur un côté du film semi-conducteur opposé au substrat ;
l'exposition de la résine photosensible et le développement de la résine photosensible pour obtenir un motif de résine photosensible ; et
la gravure du film semi-conducteur selon une direction allant de la couche épitaxiale au substrat, pour obtenir la couche épitaxiale.

5. Procédé de préparation de puce selon la revendication 4, dans lequel la précision d'alignement de la gravure du film semi-conducteur est inférieure à 100 nm.

6. Procédé de préparation de puce selon la revendication 5, dans lequel la gravure du film semi-conducteur pour obtenir la couche épitaxiale comprend :
la gravure du film semi-conducteur à l'aide d'un gaz à base de chlore, pour obtenir la couche épitaxiale.

7. Procédé de préparation de puce selon l'une quelconque des revendications 1 à 6, dans lequel la formation d'un second via sur le substrat comprend :
la gravure du substrat le long d'une direction allant du substrat à la couche épitaxiale, pour obtenir le second via.

8. Procédé de préparation de puce selon l'une quelconque des revendications 1 à 7, dans lequel, le long d'une direction allant de la première source à la seconde source, une taille du premier via est inférieure à une taille du second via.

9. Procédé de préparation de puce selon la revendication 8, dans lequel des projections orthogonales de la couche conductrice de source et du premier via sur le substrat sont comprises dans une plage du second via, et, le long de la direction allant de la première source à la seconde source, une longueur totale d'un bord de la première source opposé à la seconde source jusqu'à un bord de la seconde source opposé à la première source est inférieure à la taille du second via ; et
avant la formation d'une seconde couche conductrice, un procédé de préparation de transistor comprend également :
la formation d'une première grille (231) du premier transistor et d'une seconde grille (232) du second transistor sur le côté de la couche épitaxiale opposé au substrat, dans lequel la première grille est située sur un côté de la première source opposé à la seconde source, et la seconde grille est située sur un côté de la seconde source opposé à la première source.

10. Procédé de préparation de puce selon l'une quelconque des revendications 1 à 7, dans lequel, le long d'une direction allant de la première source à la seconde source, une taille du premier via est supérieure ou égale à une taille du second via.

11. Procédé de préparation de puce selon l'une quelconque des revendications 8 à 10, dans lequel un centre du premier via et un centre du second via se chevauchent.

12. Puce, comprenant un substrat (10) et un premier transistor et un second transistor disposés sur le substrat, dans laquelle le premier transistor comprend une première couche épitaxiale (101) et une première source (211) disposées séquentiellement sur le substrat de manière empilée, le second transistor comprend une seconde couche épitaxiale (102) et une seconde source (212) disposées séquentiellement sur le substrat de manière empilée, et un premier via est fourni entre la première couche épitaxiale et la seconde couche épitaxiale ; un bord de la première source affleure un bord de la première couche épitaxiale proche d'un côté du premier via, et un bord de la seconde source affleure un bord de la seconde couche épitaxiale proche d'un côté du premier via ; et la puce comprend également une première couche conductrice (13),
dans laquelle la première couche conductrice est en contact avec la première source et la seconde source séparément, et est remplie dans le premier via ; et
le substrat comprend un second via, et la puce comprend également une seconde couche conductrice (14),
dans laquelle la seconde couche conductrice est remplie dans le second via, et la seconde couche conductrice est en contact avec la première couche conductrice et est mise à la terre.

13. Puce selon la revendication 12, dans laquelle, le long d'une direction allant de la première source à la seconde source, une taille du premier via est inférieure à une taille du second via.

14. Puce selon la revendication 13, dans laquelle le premier transistor comprend également une première grille, et le second transistor comprend également une seconde grille ; la première grille est disposée sur un côté de la première couche épitaxiale opposé au substrat, et est située sur un côté de la première source opposé à la seconde source ; et la seconde grille est disposée sur un côté de la seconde couche épitaxiale opposé au substrat, et est située sur un côté de la seconde source opposé à la première source ; et
des projections orthogonales de la première source, du premier via et de la seconde source sur le substrat sont comprises dans une plage du second via et, le long de la direction allant de la première source à la seconde source, une longueur totale d'un bord de la première source opposé à la seconde source jusqu'à un bord de la seconde source opposé à la première source est inférieure à la taille du second via.

15. Puce selon la revendication 12, dans laquelle, le long d'une direction allant de la première source à la seconde source, une taille du premier via est supérieure ou égale à une taille du second via.
